# EUROPEAN PATENT APPLICATION

(11) **EP 4 608 093 A1**
(43) Date of publication of application: **27.08.2025**
(21) Application number: 24206939.1
(22) Date of filing: 16.10.2024
(51) Int. Cl.: H10D 89/10, H01L 23/528, H10D 84/80

(54) **SEMICONDUCTOR DEVICE AND METHOD OF FABRICATING THE SAME**

(30) Priority: 22.02.2024 KR 20240025729; 28.03.2024 KR 20240042180
(71) Applicant: Samsung Electronics Co., Ltd, Suwon-si, Gyeonggi-do 16677 (KR)
(72) Inventor: PARK, Jongsoon, 16677 Suwon-si, Gyeonggi-do (KR); RA, Hyonwook, 16677 Suwon-si, Gyeonggi-do (KR); BAI, Keunhee, 16677 Suwon-si, Gyeonggi-do (KR); LEE, Jinwook, 16677 Suwon-si, Gyeonggi-do (KR); HONG, Seongjun, 16677 Suwon-si, Gyeonggi-do (KR)
(74) Representative: Kuhnen & Wacker Patent- und Rechtsanwaltsbüro PartG mbB

(57) **Abstract**

A semiconductor device may include first and second logic cells, which are on a substrate and are spaced apart from each other in a first direction, and each of which includes PMOSFET and NMOSFET regions, and first and second metal layers on the first and second logic cells, respectively. The first metal layer may include first, second, and third right interconnection lines, which extend in the first direction parallel to each other, with the second right interconnection line between the first and third right interconnection lines. The second metal layer may include a first left interconnection line. A shortest distance between the first right interconnection line and the first left interconnection line in the first direction may be defined as a first distance that is in a range from 12 nm to 18 nm.

## Description

### CROSS-REFERENCE TO RELATED APPLICATIONS

This U.S. non-provisional patent application claims priority under 35 U.S.C. §119 to Korean Patent Application Nos. 10-2024-0025729 and 10-2024-0042180, filed on February 22, 2024 and March 28, 2024, respectively, in the Korean Intellectual Property Office, the entire contents of which are hereby incorporated by reference.

### BACKGROUND OF THE INVENTION

The present inventive concepts relate to semiconductor devices and methods of fabricating the same, and in particular, to semiconductor devices including field effect transistors and methods of fabricating the same.

A semiconductor device may include an integrated circuit composed of metal-oxide-semiconductor field-effect transistors (MOSFETs). To meet an increasing demand for a semiconductor device with a small pattern size and a reduced design rule, the MOSFETs are being aggressively scaled down. The scale-down of the MOSFETs may lead to deterioration in operational properties of the semiconductor device. A variety of studies are being conducted to overcome technical limitations associated with the reduced sizes of the semiconductor device and to realize high-performance semiconductor devices.

### SUMMARY OF THE INVENTION

Aspects of the inventive concepts provide a semiconductor device with improved electrical characteristics and reliability.

Aspects of the inventive concepts provide a method of fabricating a semiconductor device with improved electrical characteristics and reliability.

According to aspects of the inventive concepts, a semiconductor device may include a first logic cell and a second logic cell, which are on a substrate and are spaced apart from each other in a first direction, and each of which includes a PMOSFET region and an NMOSFET region, and a first metal layer on the first logic cell and a second metal layer on the second logic cell. The first metal layer may include a first right interconnection line, a second right interconnection line, and a third right interconnection line, which extend in the first direction parallel to each other, with the second right interconnection line between the first right interconnection line and the third right interconnection line. The second metal layer may include a first left interconnection line. The first right interconnection line may have a first end facing the first left interconnection line. The second right interconnection line may have a second end facing the second logic cell. The third right interconnection line may have a third end facing the second logic cell. The first and third ends may protrude beyond the second end in the first direction. A shortest distance between the first right interconnection line and the first left interconnection line in the first direction may be defined as a first distance that is in a range from 12 nm to 18 nm.

According to aspects of the inventive concepts, a semiconductor device may include a first logic cell on a substrate, the first logic cell including a PMOSFET region and an NMOSFET region, and a first metal layer on the first logic cell. The first metal layer may include first lower interconnection lines and second lower interconnection lines, which extend in a first direction parallel to each other and are spaced apart from each other. The first lower interconnection lines may include a first interconnection line and a second interconnection line, which are adjacent to each other among the first lower interconnection lines. The second lower interconnection lines may include a third interconnection line between the first interconnection line and the second interconnection line. The first interconnection line may include a first left end and a first right end, which are opposite to each other in the first direction. The second interconnection line may include a second left end and a second right end, which are opposite to each other in the first direction. The third interconnection line may include a third left end and a third right end, which are opposite to each other in the first direction. The first and second left ends may protrude beyond the third left end in the first direction. The first and second right ends may protrude beyond the third right end in the first direction.

According to aspects of the inventive concepts, a semiconductor device may include a first cell and a second cell, which are on a substrate and are adjacent to each other in a first direction. Each of the first cell and the second cell may include an active pattern on the substrate, a device isolation layer in a trench defining the active pattern, a source/drain pattern on the active pattern and a channel pattern electrically connected to the source/drain pattern, the channel pattern including a first semiconductor pattern, a second semiconductor pattern, and a third semiconductor pattern, which are sequentially stacked and spaced apart from each other, a gate electrode that crosses the channel pattern, the gate electrode including a first portion between the active pattern and the first semiconductor pattern, a second portion between the first semiconductor pattern and the second semiconductor pattern, a third portion between the second semiconductor pattern and the third semiconductor pattern, and a fourth portion on the third semiconductor pattern, a gate insulating layer between the channel pattern and the gate electrode, gate spacers on opposite side surfaces of the fourth portion of the gate electrode, respectively, a gate capping pattern on a top surface of the gate electrode, a first interlayer insulating layer on the gate capping pattern, an active contact extending in the first interlayer insulating layer and electrically connected to the source/drain pattern, a gate contact extending in the first interlayer insulating layer and electrically connected to the gate electrode, a second interlayer insulating layer on the first interlayer insulating layer, and a metal layer in the second interlayer insulating layer and electrically connected to the active contact and the gate contact. The metal layer may include a first metal layer on the first cell and a second metal layer on the second cell. The first metal layer may include a first right interconnection line, a second right interconnection line, and a third right interconnection line, which extend in the first direction parallel to each other. The second right interconnection line may be between the first right interconnection line and the third right interconnection line. The second metal layer may include a first left interconnection line. The first right interconnection line may have a first end facing the first left interconnection line. The second right interconnection line may have a second end facing the second cell. The third right interconnection line may have a third end facing the second cell. The first and third ends may be positioned beyond the second end in the first direction. A shortest distance between the first right interconnection line and the first left interconnection line in the first direction may be defined as a first distance that is in a range from 12 nm to 18 nm.

According to aspects of the inventive concepts, a method of fabricating a semiconductor device may include forming a first mold layer on a substrate, etching the first mold layer to form mold patterns, which extend in a first direction on the substrate, forming spacers on side surfaces of the mold patterns to define first open lines therebetween, forming a second mold layer in each of the first open lines, forming a hard mask pattern on the second mold layer, etching the second mold layer using the hard mask pattern as a mask to form openings exposing the mold patterns, and performing a first etching process on the openings to increase lengths of the openings, thereby forming second open lines. The first open lines and the second open lines may be alternately arranged in a second direction that is perpendicular to the first direction. Each of the second open lines may have a first endmost portion. Each of the first open lines may have a second endmost portion. The first endmost portion may protrude beyond the second endmost portion in the first direction.

### BRIEF DESCRIPTION OF THE DRAWINGS

FIGS. 1 to 3 are conceptual diagrams illustrating logic cells of a semiconductor device according to some embodiments of the inventive concepts.
FIG. 4 is a plan view illustrating a semiconductor device according to some embodiments of the inventive concepts.
FIGS. 5A to 5D are sectional views taken along lines A-A', B-B', C-C', and D-D' of FIG. 4, respectively.
FIG. 6A is a plan view illustrating first to fifth lower interconnection lines, which are respectively disposed on first to fifth interconnection tracks of FIG. 4.
FIG. 6B is a plan view illustrating a comparative example of FIG. 6A.
FIGS. 7A, 7B, 8A, 8B, 9A, 9B, 9C, 10A, 10B, 10C, 10D, 11A, 11B, 11C, 12A, 12B, and 12C are sectional views illustrating a method of fabricating a semiconductor device according to some embodiments of the inventive concepts.
FIGS. 13A, 14A, 15A, 16A, 17A, 18A, 19A, 22A, and 25A are plan views illustrating a method of fabricating a first metal layer, according to some embodiments of the inventive concepts.
FIGS. 13B, 14B, 15B, 16B, 17B, 18B, 19B, 22B, and 25B are sectional views, which are taken along lines I-I' of FIGS. 13A, 14A, 15A, 16A, 17A, 18A, 19A, 22A, and 25A, respectively.
FIGS. 23 and 24 are sectional views taken along a line I-I' of FIG. 22A.

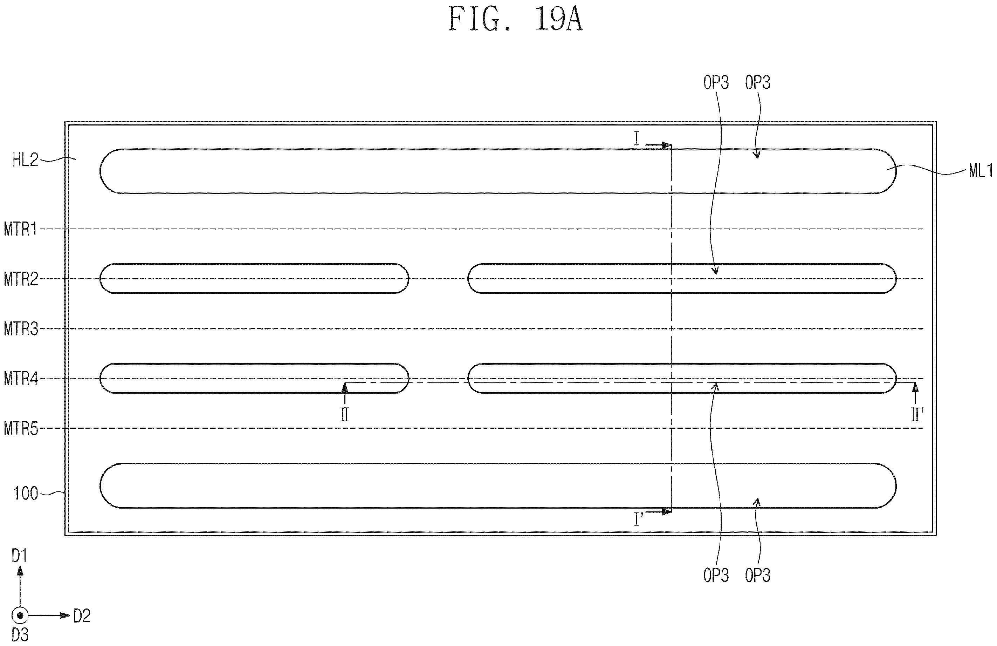

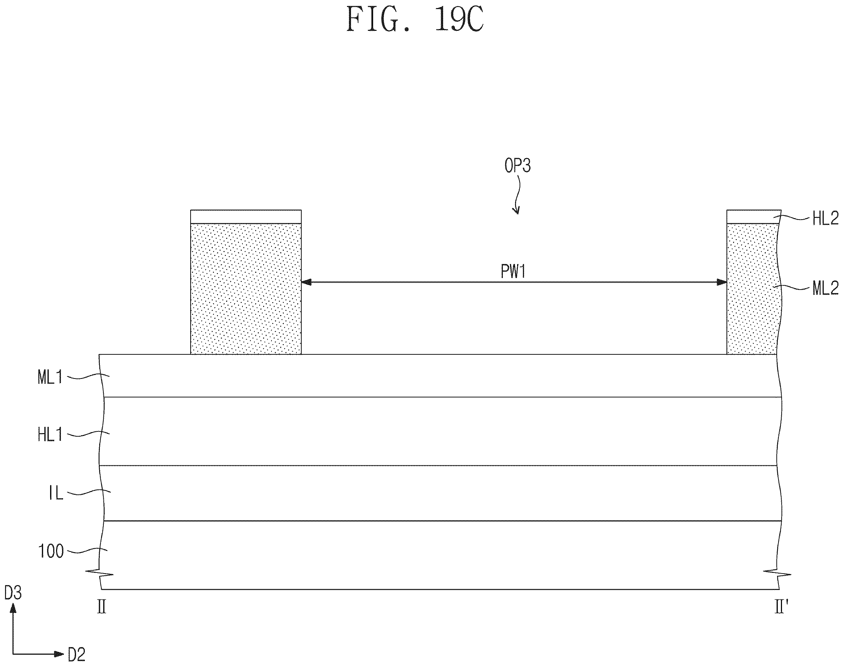

FIGS. 19C, 20, and 21 are sectional views taken along a line II-II' of FIG. 19A.

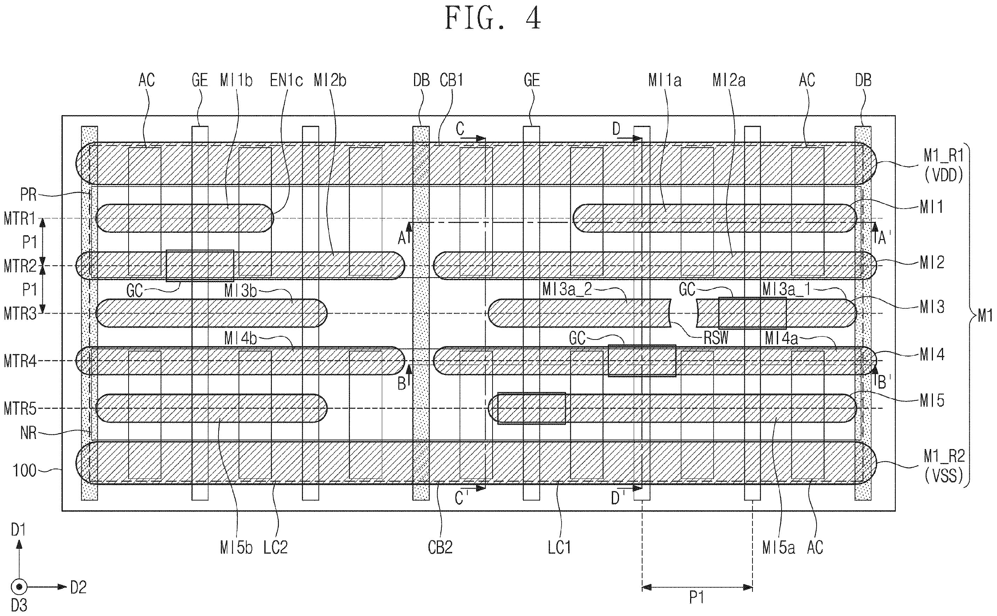

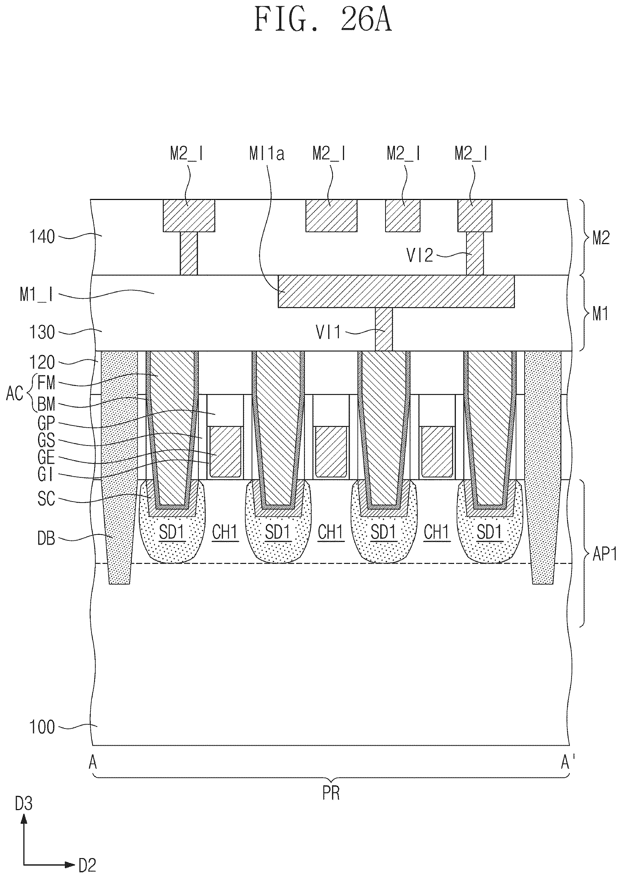

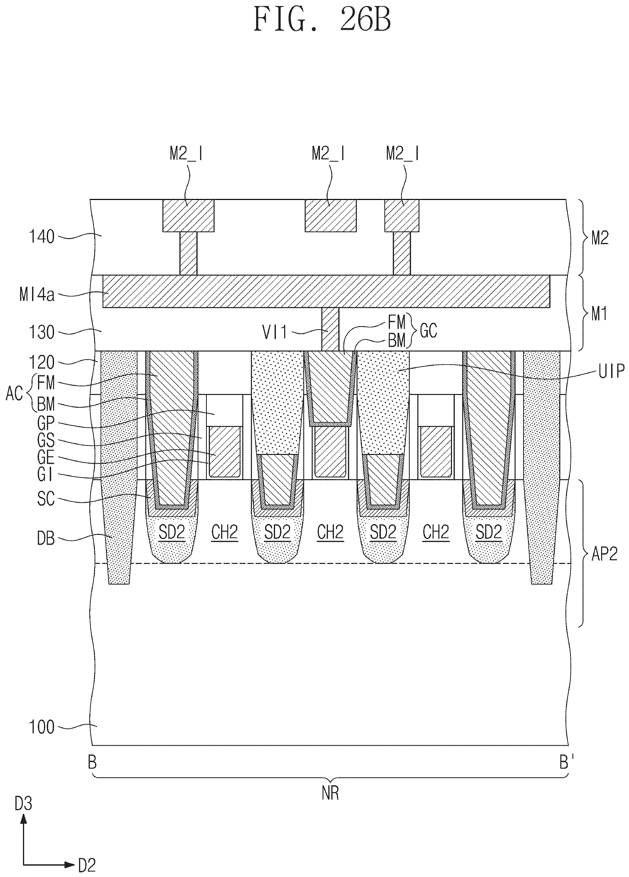

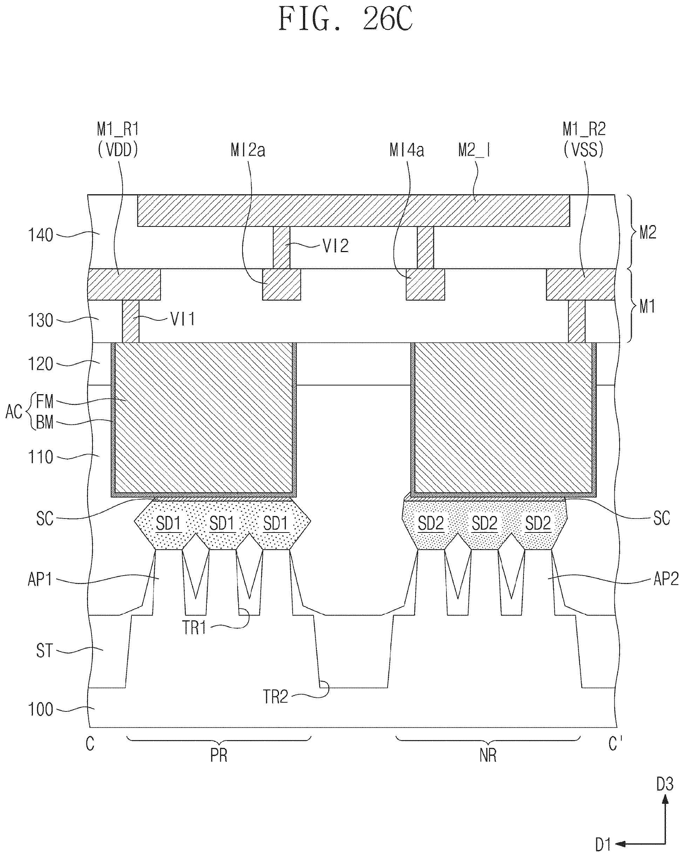

FIGS. 26A to 26D are sectional views, which are taken along lines A-A', B-B', C-C', and D-D' of FIG. 4, respectively, to illustrate a semiconductor device according to some embodiments of the inventive concepts.

### DETAILED DESCRIPTION

Example embodiments of the inventive concepts will now be described more fully with reference to the accompanying drawings, in which example embodiments are shown.

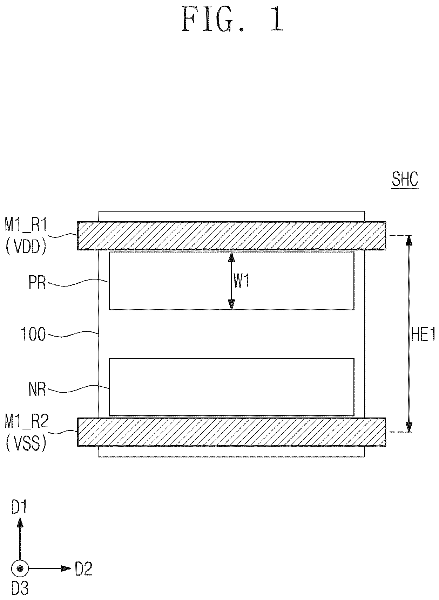

FIGS. 1 to 3 are conceptual diagrams illustrating logic cells of a semiconductor device according to some embodiments of the inventive concepts.

Referring to FIG. 1, a single height cell SHC may be provided. In detail, a first power line M1_R1 and a second power line M1_R2 may be provided on a substrate 100. The first power line M1_R1 may be a conduction path, to which a drain voltage VDD (e.g., a power voltage) is provided. The second power line M1_R2 may be a conduction path, to which a source voltage VSS (e.g., a ground voltage) is provided.

The single height cell SHC may be defined between the first power line M1_R1 and the second power line M1_R2. The single height cell SHC may include one PMOSFET region PR and one NMOSFET region NR. That is, the single height cell SHC may have a CMOS structure provided between the first power line M1_R1 and the second power line M1_R2.

Each of the PMOSFET and NMOSFET regions PR and NR may have a first width W1 in a first direction D1. A length of the single height cell SHC in the first direction D1 may be defined as a first height HE1. The first height HE1 may be substantially equal to a distance (e.g., a pitch) between the first and second power lines M1_R1 and M1_R2.

The single height cell SHC may constitute a single logic cell. In the present specification, the logic cell may mean a logic device (e.g., AND, OR, XOR, XNOR, inverter, and so forth), which is configured to execute a specific function. In other words, the logic cell may include transistors constituting the logic device and interconnection lines connecting the transistors to each other.

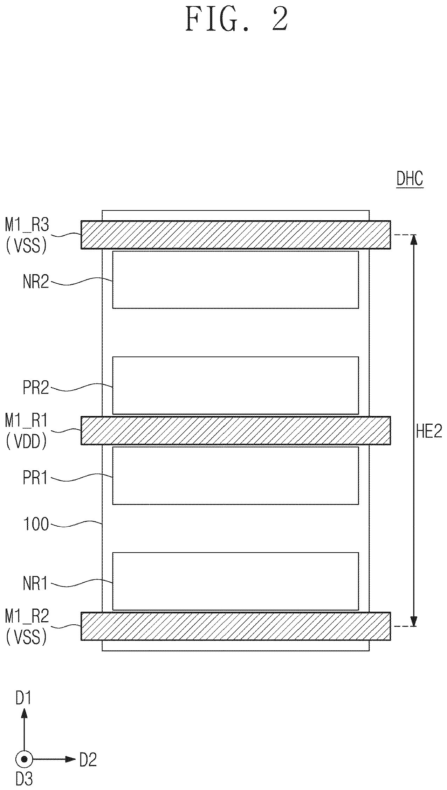

Referring to FIG. 2, a double height cell DHC may be provided. In detail, a first power line M1_R1, a second power line M1_R2, and a third power line M1_R3 may be provided on the substrate 100. The first power line M1_R1 may be disposed between the second power line M1_R2 and the third power line M1_R3. The third power line M1_R3 may be a conduction path, to which the source voltage VSS is provided.

The double height cell DHC may be defined between the second power line M1_R2 and the third power line M1_R3. The double height cell DHC may include a first PMOSFET region PR1, a second PMOSFET region PR2, a first NMOSFET region NR1, and a second NMOSFET region NR2.

The first NMOSFET region NR1 may be adjacent to the second power line M1_R2. The second NMOSFET region NR2 may be adjacent to the third power line M1_R3. The first and second PMOSFET regions PR1 and PR2 may be adjacent to the first power line M1_R1. When viewed in a plan view, the first power line M1_R1 may be disposed between the first and second PMOSFET regions PR1 and PR2.

A length of the double height cell DHC in the first direction D1 may be defined as a second height HE2. The second height HE2 may be about two times the first height HE1 of FIG. 1. The first and second PMOSFET regions PR1 and PR2 of the double height cell DHC may be combined to serve as a single PMOSFET region.

Thus, a channel size of the PMOS transistor of the double height cell DHC may be larger than a channel size of the PMOS transistor of the single height cell SHC of FIG. 1. For example, the channel size of the PMOS transistor of the double height cell DHC may be about two times the channel size of the PMOS transistor of the single height cell SHC. In this case, the double height cell DHC may be operated at a higher speed than the single height cell SHC. In some embodiments, the double height cell DHC shown in FIG. 2 may be defined as a multi-height cell. Although not shown, the multi-height cell may include a triple height cell whose cell height is about three times that of the single height cell SHC of FIG. 1.

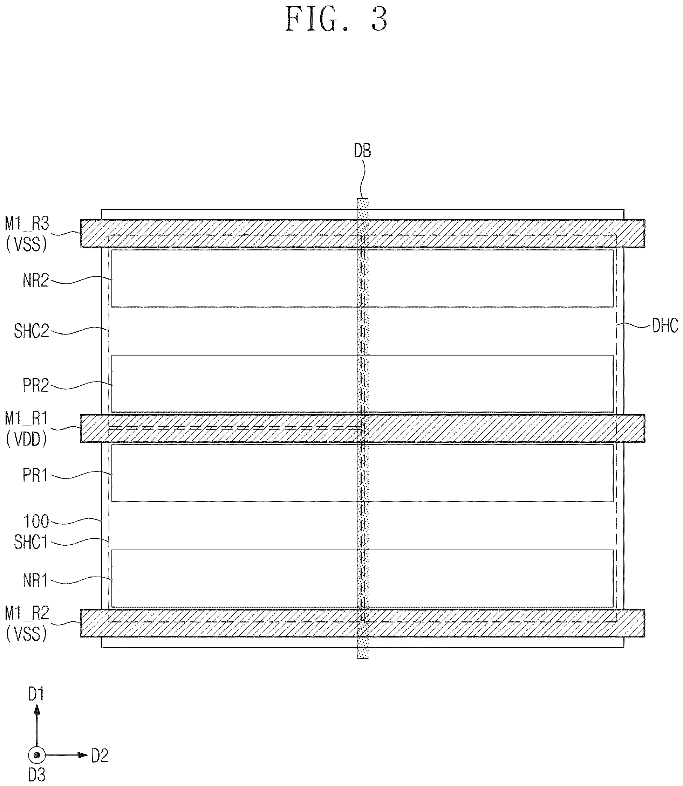

Referring to FIG. 3, a first single height cell SHC1, a second single height cell SHC2, and a double height cell DHC may be two-dimensionally arranged on the substrate 100. The first single height cell SHC1 may be disposed between the first and second power lines M1_R1 and M1_R2. The second single height cell SHC2 may be disposed between the first and third power lines M1_R1 and M1_R3. The second single height cell SHC2 may be adjacent to the first single height cell SHC1 in the first direction D1.

The double height cell DHC may be disposed between the second and third power lines M1_R2 and M1_R3. The double height cell DHC may be adjacent to the first and second single height cells SHC1 and SHC2 in a second direction D2.

A division structure DB may be provided between the first single height cell SHC1 and the double height cell DHC and between the second single height cell SHC2 and the double height cell DHC. The active region of the double height cell DHC may be electrically separated (i.e., electrically isolated) from the active region of each of the first and second single height cells SHC1 and SHC2 by the division structure DB.

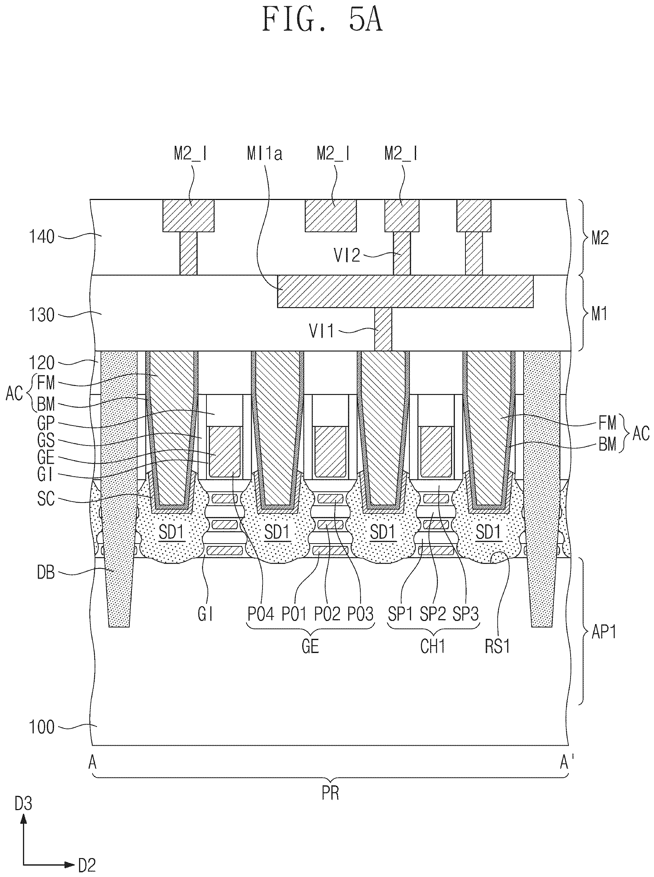

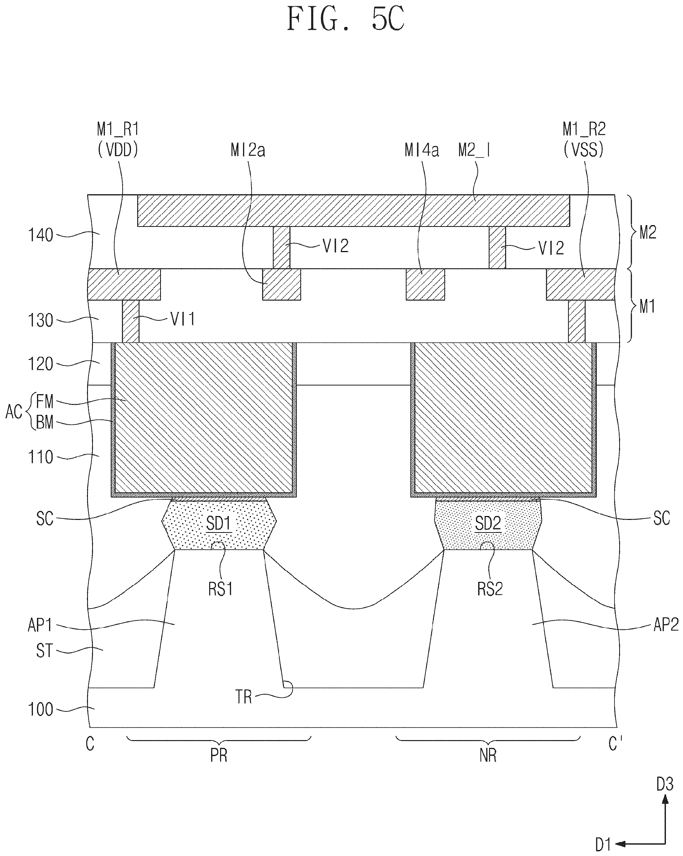

FIG. 4 is a plan view illustrating a semiconductor device according to some embodiments of the inventive concepts. FIGS. 5A to 5D are sectional views taken along lines A-A', B-B', C-C', and D-D' of FIG. 4, respectively.

Referring to FIGS. 4 and 5A to 5D, a plurality of logic cells LC1 and LC2 may be provided on the substrate 100. The substrate 100 may be a semiconductor substrate that is formed of or includes silicon, germanium, silicon germanium, a compound semiconductor material, or the like. As an example, the substrate 100 may be a silicon substrate (e.g., a silicon wafer).

The single height cell SHC (see FIG. 1) may be provided on the substrate 100. Logic transistors constituting a logic circuit may be disposed on the single height cell SHC. For example, the logic cells LC1 and LC2 may each be a single height cell SHC, but the inventive concepts are not limited thereto.

For example, the logic cells LC1 and LC2 may include a first logic cell LC1 and a second logic cell LC2, which are adjacent to each other in the second direction D2. Logic transistors may be disposed on each of the first and second logic cells LC1 and LC2 to constitute the logic circuit. Each of the first and second logic cells LC1 and LC2 may include a PMOSFET region PR and an NMOSFET region NR. The PMOSFET and NMOSFET regions PR and NR may be spaced apart from each other in the first direction D1.

A first active pattern AP1 and a second active pattern AP2 may be defined by a trench TR, which is formed in an upper portion of the substrate 100. The first and second active patterns AP1 and AP2 may be provided on the PMOSFET and NMOSFET regions PR and NR, respectively. The first and second active patterns AP1 and AP2 may extend in the second direction D2. Each of the first and second active patterns AP1 and AP2 may be a vertically-protruding portion of the substrate 100 (e.g., protruding in a third direction D3). For example, the first and second directions D1 and D2 may intersect each other and may be substantially parallel to a lower surface of the substrate 100. For example, the third direction D3 may intersect the first and second directions D1 and D2 and may be substantially perpendicular to the lower surface of the substrate 100.

A device isolation layer ST may be provided in (e.g., to fill) the trench TR. The device isolation layer ST may include a silicon oxide layer. The device isolation layer ST may not cover first and second channel patterns CH1 and CH2, which will be described below.

A first channel pattern CH1 may be provided on the first active pattern AP1. A second channel pattern CH2 may be provided on the second active pattern AP2. Each of the first and second channel patterns CH1 and CH2 may include a first semiconductor pattern SP1, a second semiconductor pattern SP2, and a third semiconductor pattern SP3, which are sequentially stacked. The first to third semiconductor patterns SP1, SP2, and SP3 may be spaced apart from each other in a vertical direction (i.e., a third direction D3).

Each of the first to third semiconductor patterns SP1, SP2, and SP3 may be formed of or include at least one of silicon (Si), germanium (Ge), or silicon germanium (SiGe). For example, each of the first to third semiconductor patterns SP1, SP2, and SP3 may be formed of or include crystalline silicon. In some embodiments, the first to third semiconductor patterns SP1, SP2, and SP3 may be stacked nanosheets.

A plurality of first source/drain patterns SD1 may be provided on the first active pattern AP 1. A plurality of first recesses RS1 may be formed in an upper portion of the first active pattern AP1. The first source/drain patterns SD1 may be provided in the first recesses RS1, respectively. The first source/drain patterns SD1 may be impurity regions of a first conductivity type (e.g., p-type). The first channel pattern CH1 may be interposed between each pair of the first source/drain patterns SD1. In other words, each pair of the first source/drain patterns SD1 may be connected to each other by the stacked first to third semiconductor patterns SP1, SP2, and SP3. As used herein, "an element A connected to an element B" (or similar language) means that the element A is electrically and/or physically connected to the element B.

A plurality of second source/drain patterns SD2 may be provided on the second active pattern AP2. A plurality of second recesses RS2 may be formed in an upper portion of the second active pattern AP2. The second source/drain patterns SD2 may be provided in the second recesses RS2, respectively. The second source/drain patterns SD2 may be impurity regions of a second conductivity type (e.g., n-type). The second channel pattern CH2 may be interposed between each pair of the second source/drain patterns SD2. In other words, each pair of the second source/drain patterns SD2 may be connected to each other by the stacked first to third semiconductor patterns SP1, SP2, and SP3.

The first and second source/drain patterns SD1 and SD2 may be epitaxial patterns, which are formed by a selective epitaxial growth (SEG) process. As an example, a top surface of each of the first and second source/drain patterns SD1 and SD2 may be positioned at substantially the same level as (i.e., may be substantially coplanar with) a top surface of the third semiconductor pattern SP3. In other embodiments, the top surface of each of the first and second source/drain patterns SD1 and SD2 may be higher than the top surface of the third semiconductor pattern SP3 (e.g., relative to the lower surface of the substrate 100).

In some embodiments, the first source/drain patterns SD1 may be formed of or include a semiconductor material (e.g., SiGe) whose lattice constant is greater than that of a semiconductor material of the substrate 100. In this case, the pair of the first source/drain patterns SD1 may exert a compressive stress on the first channel patterns CH1 therebetween. The second source/drain patterns SD2 may be formed of or include the same semiconductor element (e.g., Si) as the substrate 100.

A side surface of each of the first and second source/drain patterns SD1 and SD2 may have an uneven or embossing shape. In other words, the side surface of each of the first and second source/drain patterns SD1 and SD2 may have a wavy profile. The side surface of each of the first and second source/drain patterns SD1 and SD2 may protrude toward first to third portions PO1, PO2, and PO3 of a gate electrode GE to be described below.

Gate electrodes GE may be provided to cross the first and second channel patterns CH1 and CH2 and to extend in the first direction D1. The gate electrodes GE may be arranged at a first pitch P1 in the second direction D2. Each of the gate electrodes GE may be vertically overlapped with the first and second channel patterns CH1 and CH2. As used herein, "an element A overlaps an element B in a direction X" (or similar language) means that there is at least one straight line that extends in the direction X and intersects both the elements A and B.

The gate electrode GE may include a first portion PO1 interposed between the active pattern AP1 or AP2 and the first semiconductor pattern SP1, a second portion PO2 interposed between the first semiconductor pattern SP1 and the second semiconductor pattern SP2, a third portion PO3 interposed between the second semiconductor pattern SP2 and the third semiconductor pattern SP3, and a fourth portion PO4 on the third semiconductor pattern SP3.

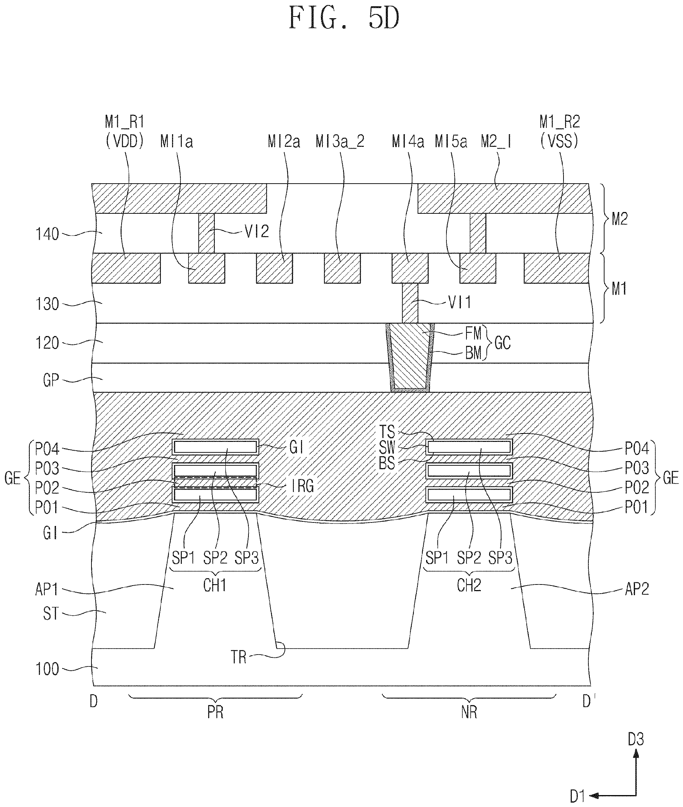

Referring to FIG. 5D, the gate electrode GE may be provided on a top surface TS, a bottom surface BS, and opposite side surfaces SW of each of the first to third semiconductor patterns SP1, SP2, and SP3. That is, the transistor according to some embodiments may be a three-dimensional field effect transistor (e.g., MBCFET or GAAFET) in which the gate electrode GE is provided to three-dimensionally surround the channel pattern.

Referring to FIGS. 4 and 5A to 5D, a pair of gate spacers GS may be respectively disposed on opposite side surfaces of the fourth portion PO4 of the gate electrode GE. The gate spacers GS may extend along the gate electrode GE and in the first direction D1. Top surfaces of the gate spacers GS may be higher than a top surface of the gate electrode GE (e.g., relative to the lower surface of the substrate 100). The top surfaces of the gate spacers GS may be substantially coplanar with a top surface of a first interlayer insulating layer 110, which will be described below. In some embodiments, the gate spacers GS may be formed of or include at least one of silicon carbon nitride (SiCN), silicon carbon oxynitride (SiCON), or silicon nitride (SiN). In other embodiments, the gate spacers GS may be provided to have a multi-layered structure, which includes at least two different materials selected from silicon carbon nitride (SiCN), silicon carbon oxynitride (SiCON), and silicon nitride (SiN).

A gate capping pattern GP may be provided on the gate electrode GE. The gate capping pattern GP may extend along the gate electrode GE and in the first direction D1. The gate capping pattern GP may be formed of or include a material having an etch selectivity with respect to first and second interlayer insulating layers 110 and 120, which will be described below. In detail, the gate capping pattern GP may be formed of or include at least one of silicon oxynitride (SiON), silicon carbon nitride (SiCN), silicon carbon oxynitride (SiCON), or silicon nitride (SiN).

A gate insulating layer GI may be interposed between the gate electrode GE and the first channel pattern CH1 and between the gate electrode GE and the second channel pattern CH2. The gate insulating layer GI may be on (e.g., may cover) the top surface TS, the bottom surface BS, and the side surfaces SW of each of the first to third semiconductor patterns SP1, SP2, and SP3. The gate insulating layer GI may be on (e.g., may cover) a top surface of the device isolation layer ST placed below the gate electrode GE.

In some embodiments, the gate insulating layer GI may include a silicon oxide layer, a silicon oxynitride layer, and/or a high-k dielectric layer. The high-k dielectric layer may be formed of or include at least one of high-k dielectric materials whose dielectric constants are higher than that of silicon oxide. For example, the high-k dielectric material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

Referring to FIGS. 4 and 5A to 5D, the gate electrode GE may include a first metal pattern and a second metal pattern on the first metal pattern. The first metal pattern may be provided on the gate insulating layer GI and may be adjacent to the first to third semiconductor patterns SP1, SP2, and SP3. The first metal pattern may include a work-function metal, which can be used to adjust a threshold voltage of the transistor. By adjusting a thickness and composition of the first metal pattern, it may be possible to realize a transistor having a desired threshold voltage. For example, the first and second portions PO1 and PO2 of the gate electrode GE may be composed of the first metal pattern or the work-function metal.

The first metal pattern may include a metal nitride layer. For example, the first metal pattern may include a layer that is composed of at least one metallic material, which is selected from the group consisting of titanium (Ti), tantalum (Ta), aluminum (Al), tungsten (W) and molybdenum (Mo). In some embodiments, the first metal pattern may further include carbon (C) and/or nitrogen (N). The first metal pattern may include a plurality of work function metal layers which are stacked.

The second metal pattern may be formed of or include a metallic material whose resistance is lower than the first metal pattern. For example, the second metal pattern may be formed of or include at least one metallic material, which is selected from the group consisting of tungsten (W), aluminum (Al), titanium (Ti), and tantalum (Ta). For example, the third portion PO3 of the gate electrode GE may include the first metal pattern and the second metal pattern on the first metal pattern.

A first interlayer insulating layer 110 may be provided on the substrate 100. The first interlayer insulating layer 110 may be on (e.g., may cover) the gate spacers GS and the first and second source/drain patterns SD1 and SD2. A top surface of the first interlayer insulating layer 110 may be substantially coplanar with a top surface of the gate capping pattern GP and a top surface of the gate spacer GS. A second interlayer insulating layer 120 may be formed on the first interlayer insulating layer 110 to be on (e.g., to cover) the gate capping pattern GP. In some embodiments, each of the first and second interlayer insulating layers 110 and 120 may include a silicon oxide layer.

A pair of division structures DB may be provided at both sides of each of the first and second logic cells LC1 and LC2 to be opposite to each other in the second direction D2. For example, the division structure DB may be provided on a boundary between the first and second logic cells LC1 and LC2. The division structure DB may extend in the first direction D1 parallel to the gate electrodes GE.

The division structure DB may be provided to penetrate (i.e., extend in) the first and second interlayer insulating layers 110 and 120 and may extend into the first and second active patterns AP1 and AP2. The division structure DB may penetrate the first and second channel patterns CH1 and CH2. The division structure DB may be provided to separate the PMOSFET and NMOSFET regions PR and NR of the first logic cell LC1 from the PMOSFET and NMOSFET regions PR and NR of the second logic cell LC2.

Active contacts AC may be provided to penetrate the first and second interlayer insulating layers 110 and 120 and to be electrically connected to the first and second source/drain patterns SD1 and SD2, respectively. The active contacts AC may be respectively provided at both sides of the gate electrode GE. When viewed in a plan view, the active contact AC may be a bar-shaped pattern that extends in the first direction D1.

The active contact AC may be a self-aligned contact. For example, the active contact AC may be formed by a self-alignment process using the gate capping pattern GP and the gate spacer GS. For example, the active contact AC may cover at least a portion of the side surface of the gate spacer GS. Although not shown, the active contact AC may be on (e.g., may cover) a portion of the top surface of the gate capping pattern GP.

Silicide patterns SC may be respectively interposed between the active contact AC and the first source/drain pattern SD1 and between the active contact AC and the second source/drain pattern SD2. The active contacts AC may be electrically connected to the first and second source/drain patterns SD1 and SD2 through the silicide patterns SC, respectively. The silicide pattern SC may be formed of or include at least one of metal silicide materials (e.g., titanium silicide, tantalum silicide, tungsten silicide, nickel silicide, and cobalt silicide).

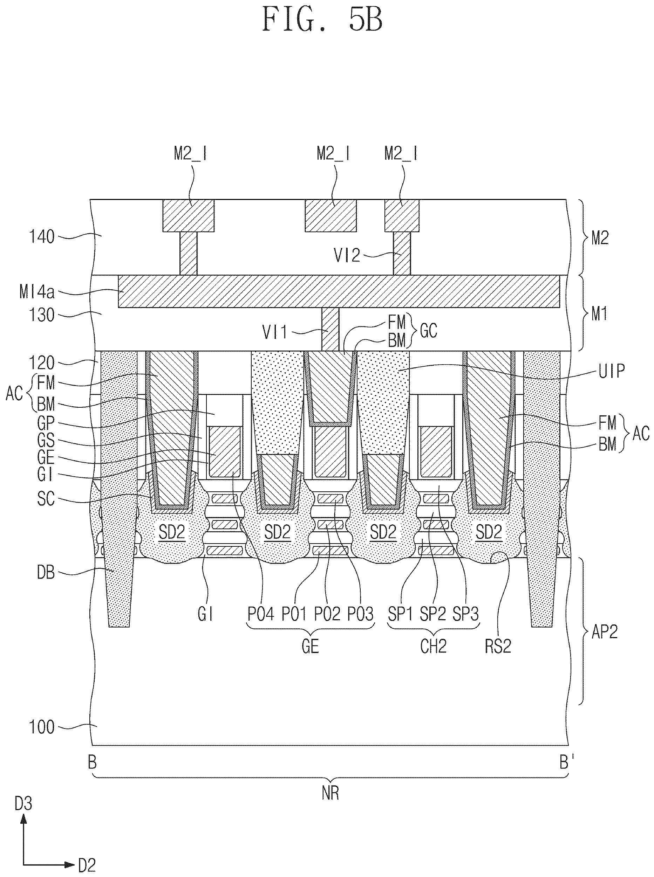

A gate contact GC may be provided to penetrate the second interlayer insulating layer 120 and the gate capping pattern GP and may be electrically connected to the gate electrode GE. As shown in FIG. 5B, an upper region of each of the active contacts AC adjacent to the gate contact GC may be filled with an upper insulating pattern UIP. Accordingly, it may be possible to prevent a process failure (e.g., a short circuit), which may occur when the gate contact GC is in contact with the active contact AC adjacent thereto.

Each of the active and gate contacts AC and GC may include a conductive pattern FM and a barrier pattern BM surrounding the conductive pattern FM. For example, the conductive pattern FM may be formed of or include at least one of metallic materials (e.g., aluminum, copper, tungsten, molybdenum, and cobalt). The barrier pattern BM may be provided to be on (e.g., to cover) side and bottom surfaces of the conductive pattern FM. In some embodiments, the barrier pattern BM may include a metal layer and a metal nitride layer. The metal layer may be formed of or include at least one of titanium, tantalum, tungsten, nickel, cobalt, or platinum. The metal nitride layer may be formed of or include at least one of titanium nitride (TiN), tantalum nitride (TaN), tungsten nitride (WN), nickel nitride (NiN), cobalt nitride (CoN), or platinum nitride (PtN).

A first metal layer M1 may be provided in a third interlayer insulating layer 130. The first metal layer M1 may include a first power line M1_R1, a second power line M1_R2, first to fifth lower interconnection lines MI1 to MI5, and lower vias VI1. The lower vias VI1 may be provided below the first power line M1_R1, the second power line M1_R2, and the first to fifth lower interconnection lines MI1 to MI5. As used herein, the first metal layer M1 on the first logic cell LC1 may be referred to as a first metal layer M1, and the first metal layer on the second logic cell LC2 may be referred to as a second metal layer M1.

The first and second power lines M1_R1 and M1_R2 may extend in the second direction D2 to cross the first and second logic cells LC1 and LC2 and to be parallel to each other. The drain voltage VDD and the source voltage VSS may be applied to the first and second power lines M1_R1 and M1_R2, respectively.

As shown in FIG. 4, a first cell boundary CB1, which extends in the second direction D2, may be defined in each of the first and second logic cells LC1 and LC2. A second cell boundary CB2, which extends in the second direction D2, may be defined at an opposite side of the first cell boundary CB1. The first power line M1_R1, which is applied with the drain voltage VDD, may be disposed on the first cell boundary CB1. In other words, the first power line M1_R1, which is applied with the drain voltage VDD, may extend along the first cell boundary CB1 in the second direction D2. The second power line M1_R2, which is applied with the source voltage VSS (i.e., the ground voltage), may be disposed on the second cell boundary CB2. In other words, the second power line M1_R2, which is applied with the source voltage VSS, may extend along the second cell boundary CB2 in the second direction D2.

First to fifth lower interconnection lines MI1 to MI5 may be disposed between the first power line M1_R1 and the second power line M1_R2. In detail, first to fifth interconnection tracks MTR1 to MTR5 may be defined between the first power line M1_R1 and the second power line M1_R2. The first to fifth interconnection tracks MTR1 to MTR5 may extend in the second direction D2 to be parallel to each other. The first to fifth lower interconnection lines MI1 to MI5 may be arranged at the first pitch P1 in the first direction D1. Additional interconnection tracks may be disposed between the first power line M1_R1 and the second power line M1_R2. In some embodiments, at least one of the first to fifth interconnection tracks MTR1 to MTR5 may be omitted.

One or more first lower interconnection lines MI1 may be disposed on the first interconnection track MTR1, one or more second lower interconnection lines MI2 may be disposed on the second interconnection track MTR2, one or more third lower interconnection lines MI3 may be disposed on the third interconnection track MTR3, one or more fourth lower interconnection lines MI4 may be disposed on the fourth interconnection track MTR4, and one or more fifth lower interconnection lines MI5 may be disposed on the fifth interconnection track MTR5.

The first to fifth lower interconnection lines MI1 to MI5 may extend along the first to fifth interconnection tracks MTR1 to MTR5, respectively, in the second direction D2 and may be parallel to each other. When viewed in a plan view, each of the first to fifth lower interconnection lines MI1 to MI5 may be a line- or bar-shaped pattern.

The lower vias VI1 may be interposed between the first and second power lines M1_R1 and M1_R2 and the active contacts AC (e.g., in the third direction D3). The lower vias VI1 may be interposed between the first to fifth lower interconnection lines MI1 to MI5 and the active and gate contacts AC and GC (e.g., in the third direction D3).

For example, the first and second power lines M1_R1 and M1_R2 and the first to fifth lower interconnection lines MI1 to MI5 may be formed of or include at least one of metallic materials (e.g., copper (Cu), aluminum (Al), ruthenium (Ru), cobalt (Co), tungsten (W), and molybdenum (Mo)).

The first and second power lines M1_R1, M1_R2, and the first to fifth lower interconnection lines MI1 to MI5 of the first metal layer M1 and the lower via VI1 thereunder may be formed by separate processes. That is, each of the first and second power lines M1_R1, M1_R2, and the first to fifth lower interconnection lines MI1 to MI5 and the lower via VI1 of the first metal layer M1 may be formed by a single damascene process.

A second metal layer M2 may be provided in a fourth interlayer insulating layer 140. The second metal layer M2 may include upper interconnection lines M2_I. Each of the upper interconnection lines M2_I may be a line- or bar-shaped pattern extending in the first direction D1. In other words, the upper interconnection lines M2_I may extend in the first direction D1 parallel to each other.

The second metal layer M2 may further include upper vias VI2. The upper vias VI2 may be provided below the upper interconnection lines M2_I. The upper vias VI2 may be respectively interposed between the first and second power lines M1_R1, M1_R2, and the first to fifth lower interconnection lines MI1 to MI5 of the first metal layer M1 and the upper interconnection lines M2_I (e.g., in the third direction D3).

The upper interconnection line M2_I of the second metal layer M2 and the upper via VI2 thereunder may be formed by the same process and may form a single object (e.g., a monolithic object). For example, the upper interconnection line M2_I and the upper via VI2 of the second metal layer M2 may be formed together by a dual damascene process. The upper interconnection lines M2_I may be formed of or include at least one of metallic materials (e.g., copper (Cu), aluminum (Al), ruthenium (Ru), cobalt (Co), tungsten (W), and molybdenum (Mo)).

In some embodiments, although not shown, additional metal layers (e.g., M3, M4, M5, and so forth) may be further stacked on the fourth interlayer insulating layer 140. Each of the stacked metal layers may include routing lines.

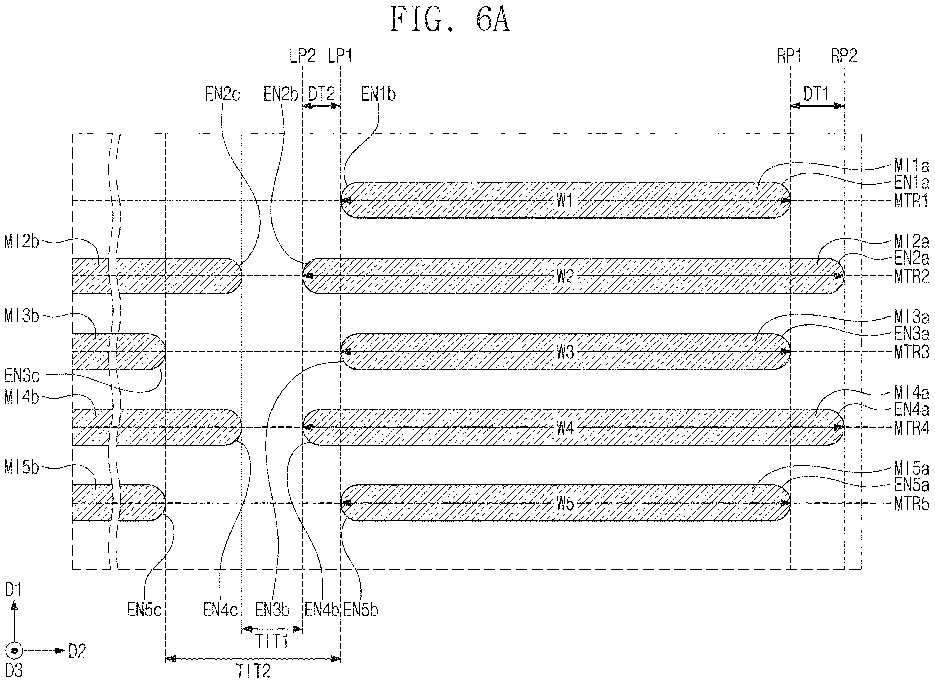

FIG. 6A is a plan view illustrating the first to fifth lower interconnection lines MI1 to MI5, which are respectively disposed on the first to fifth interconnection tracks MTR1 to MTR5 of FIG. 4. The interconnection lines of the first metal layer M1 will be described in more detail with reference to FIG. 6A.

Referring to FIGS. 4 and 6A, the first lower interconnection lines MI1, which are disposed on the first interconnection track MTR1, may include a first right interconnection line MI1a and a first left interconnection line MI1b. The second lower interconnection lines MI2, which are disposed on the second interconnection track MTR2, may include a second right interconnection line MI2a and a second left interconnection line MI2b. The third lower interconnection lines MI3, which are disposed on the third interconnection track MTR3, may include a third right interconnection line MI3a and a third left interconnection line MI3b. The fourth lower interconnection lines MI4, which are disposed on the fourth interconnection track MTR4, may include a fourth right interconnection line MI4a and a fourth left interconnection line MI4b. The fifth lower interconnection lines MI5, which are disposed on the fifth interconnection track MTR5, may include a fifth right interconnection line MI5a and a fifth left interconnection line MI5b.

As shown in FIG. 4, the first to fifth right interconnection lines MI1a to MI5a may be disposed on the first logic cell LC1. For example, the first to fifth right interconnection lines MI1a to MI5a may be included in the first metal layer M1 on the first logic cell LC1. The first to fifth left interconnection lines MI1b to MI5b may be disposed on the second logic cell LC2. For example, the first to fifth left interconnection lines MI1b to MI5b may be included in the first metal layer M1 (which may also be referred to as a second metal layer M1) on the second logic cell LC2. The third right interconnection line MI3a may include a first separated interconnection line MI3a_1 and a second separated interconnection line MI3a_2. The first and second separated interconnection lines MI3a_1 and MI3a_2 may be separated from each other by the third interlayer insulating layer 130 (e.g., in the second direction D2). As shown in FIG. 6A, in some embodiments, the first and second separated interconnection lines MI3a_1 and MI3a_2 may be omitted. In other words, in some embodiments, the third right interconnection line MI3a may not include separated interconnection lines (i.e., may not include separated portions).

The first right interconnection line MI1a may be spaced apart from the first left interconnection line MI1b in the second direction D2. The second right interconnection line MI2a may be spaced apart from the second left interconnection line MI2b in the second direction D2. The third right interconnection line MI3a may be spaced apart from the third left interconnection line MI3b in the second direction D2. The fourth right interconnection line MI4a may be spaced apart from the fourth left interconnection line MI4b in the second direction D2. The fifth right interconnection line MI5a may be spaced apart from the fifth left interconnection line MI5b in the second direction D2.

The first left interconnection line MI1b may correspond to the first right interconnection line MI1a. The second left interconnection line MI2b may correspond to the second right interconnection line MI2a. The third left interconnection line MI3b may correspond to the third right interconnection line MI3a. The fourth left interconnection line MI4b may correspond to the fourth right interconnection line MI4a. The fifth left interconnection line MI5b may correspond to the fifth right interconnection line MI5a.

The first to fifth right interconnection lines MI1a to MI5a may have first to fifth lengths W1 to W5, respectively, in the second direction D2. The second length W2 may be larger (i.e., longer) than the first length W1, the third length W3, and the fifth length W5. The fourth length W4 may be larger than the first length W1, the third length W3, and the fifth length W5. As used herein, the second and fourth right interconnection lines MI2a and MI4a may also be referred to as first lower interconnection lines. As used herein, the first, third, and fifth right interconnection lines MI1a, MI3a, and MI5a may also be referred to as second lower interconnection lines.

The first right interconnection line MI1a may have one end, which will be referred to as a first right end EN1a, and an opposite end, which will be referred to as a first left end EN1b. The second right interconnection line MI2a may have one end, which will be referred to as a second right end EN2a, and an opposite end, which will be referred to as a second left end EN2b. The third right interconnection line MI3a may have one end, which will be referred to as a third right end EN3a, and an opposite end, which will be referred to as a third left end EN3b. The fourth right interconnection line MI4a may have one end, which will be referred to as a fourth right end EN4a, and an opposite end, which will be referred to as a fourth left end EN4b. The fifth right interconnection line MI5a may have one end, which will be referred to as a fifth right end EN5a, and an opposite end, which will be referred to as a fifth left end EN5b.

Each of the first right end EN1a and the first left end EN1b may be the endmost portion of the first right interconnection line MI1a. Each of the second right end EN2a and the second left end EN2b may be the endmost portion of the second right interconnection line MI2a. Each of the third right end EN3a and the third left end EN3b may be the endmost portion of the third right interconnection line MI3a. Each of the fourth right end EN4a and the fourth left end EN4b may be the endmost portion of the fourth right interconnection line MI4a. Each of the fifth right end EN5a and the fifth left end EN5b may be the endmost portion of the fifth right interconnection line MI5a.

The first right end EN1a may be opposite to the first left end EN1b in the second direction D2. The second right end EN2a may be opposite to the second left end EN2b in the second direction D2. The third right end EN3a may be opposite to the third left end EN3b in the second direction D2. The fourth right end EN4a may be opposite to the fourth left end EN4b in the second direction D2. The fifth right end EN5a may be opposite to the fifth left end EN5b in the second direction D2.

A first right position RP1 and a second right position RP2 may be defined at a side of the first logic cell LC1. A first left position LP1 and a second left position LP2 may be defined at an opposite side of the first logic cell LC 1. Each of the first and second right position RP1 and RP2 and the first and second left position LP1 and LP2 may be an imaginary line that extends in the first direction D1.

The first right end EN1a, the third right end EN3a, and the fifth right end EN5a may be placed on the first right position RP1. The second right end EN2a and the fourth right end EN4a may be placed on the second right position RP2. The second right position RP2 may be spaced apart from the first right position RP1 by a first distance DT1 in the second direction D2. The second right position RP2 may be shifted from the first right position RP1, by the first distance DT1, in the second direction D2. The first distance DT1 may range from 2 nanometers (nm) to 10 nm.

Each of the second right end EN2a and the fourth right end EN4a may protrude relative to the first right end EN1a, the third right end EN3a, and the fifth right end EN5a, by the first distance DT1, in the second direction D2. In other words, the second and fourth right ends EN2a and EN4a may protrude beyond the first right end EN1a, the third right end EN3a, and the fifth right end EN5a in the second direction D2 by the first distance DT1 (e.g., in a range from 2 nm to 10 nm). Each of the second right end EN2a and the fourth right end EN4a may be offset from the first right end EN1a, the third right end EN3a, and the fifth right end EN5a in the second direction D2. In other words, the second and fourth right ends EN2a and EN4a may be positioned beyond the first right end EN1a, the third right end EN3a, and the fifth right end EN5a in the second direction D2.

The first left end EN1b, the third left end EN3b, and the fifth left end EN5b may be placed on the first left position LP1. The second left end EN2b and the fourth left end EN4b may be placed on the second left position LP2. The first left position LP1 may be spaced apart from the second left position LP2 by a second distance DT2 in the second direction D2. The first left position LP1 may be shifted from the second left position LP2, by the second distance DT2, in the second direction D2. The second distance DT2 may range from 2 nm to 10 nm.

The second left end EN2b and the fourth left end EN4b may protrude relative to the first left end EN1b, the third left end EN3b, and the fifth left end EN5b, by the second distance DT2, in the second direction D2. In other words, the second and fourth left ends EN2b and EN4b may protrude beyond the first left end EN1b, the third left end EN3b, and the fifth left end EN5b in the second direction D2 by the second distance DT2 (e.g., in a range from 2 nm to 10 nm). Each of the second left end EN2b and the fourth left end EN4b may be offset from the first left end EN1b, the third left end EN3b, and the fifth left end EN5b in the second direction D2. In other words, the second and fourth left ends EN2b and EN4b may be positioned beyond the first left end EN1b, the third left end EN3b, and the fifth left end EN5b in the second direction D2. It will be understood that the second direction D2 includes directions that move both left to right and right to left in FIGS. 4 and 6A.

The first to fifth left interconnection lines MI1b to MI5b may have sixth to tenth lengths, respectively, in the second direction D2. The seventh length may be larger than the sixth length, the eighth length, and the tenth length. The ninth length may be larger than the sixth length, the eighth length, and the tenth length.

The first left interconnection line MI1b may include a sixth right end at a side thereof. The second left interconnection line MI2b may include a seventh right end EN2c at a side thereof. The third left interconnection line MI3b may include an eighth right end EN3c at a side thereof. The fourth left interconnection line MI4b may include a ninth right end EN4c at a side thereof. The fifth left interconnection line MI5b may include a tenth right end EN5c at a side thereof.

The sixth right end may be the endmost portion of the first left interconnection line MI1b. The seventh right end EN2c may be the endmost portion of the second left interconnection line MI2b. The eighth right end EN3c may be the endmost portion of the third left interconnection line MI3b. The ninth right end EN4c may be the endmost portion of the fourth left interconnection line MI4b. The tenth right end EN5c may be the endmost portion of the fifth left interconnection line MI5b.

The sixth right end and the first left end EN1b may face each other in the second direction D2. The seventh right end EN2c and the second left end EN2b may face each other in the second direction D2. The eighth right end EN3c and the third left end EN3b may face each other in the second direction D2. The ninth right end EN4c and the fourth left end EN4b may face each other in the second direction D2. The tenth right end EN5c and the fifth left end EN5b may face each other in the second direction D2.

The sixth to tenth right ends EN1c to EN5c may be provided to have substantially the same features of the first to fifth right ends EN1a to EN5a, respectively. In detail, each of the seventh right end EN2c and the ninth right end EN4c may protrude relative to the sixth right end EN1c, the eighth right end EN3c, and the tenth right end EN5c, by the first distance DT1, in the second direction D2. In other words, the seventh and ninth right ends EN2c and EN4c may protrude beyond the sixth right end EN1c, the eighth right end EN3c, and the tenth right end EN5c in the second direction D2 by the first distance DT1 (e.g., in a range from 2 nm to 10 nm). Each of the seventh right end EN2c and the ninth right end EN4c may be offset from the sixth right end EN1c, the eighth right end EN3c, and the tenth right end EN5c in the second direction D2. In other words, the seventh and ninth right ends EN2c and EN4c may be positioned beyond the sixth right end EN1c, the eighth right end EN3c, and the tenth right end EN5c in the second direction D2.

The shortest distance between the seventh right end EN2c and the second left end EN2b in the second direction D2 may be a first distance TIT1. The first distance TIT1 may range from 12 nm to 18 nm. The shortest distance between the eighth right end EN3c and the third left end EN3b in the second direction D2 may be a second distance TIT2. The second distance TIT2 may be larger than the first distance TIT1.

The shortest distance between the ninth right end EN4c and the fourth left end EN4b in the second direction D2 may be equal to the first distance TIT1. The shortest distance between the tenth right end EN5c and the fifth left end EN5b in the second direction D2 may be equal to the second distance TIT2. Distances between the first to fifth left ends EN1b to EN5b and the sixth to tenth right ends EN1c to EN5c may increase and decrease in an alternating manner.

Each of the first to fifth right ends EN1a to EN5a, the first to fifth left ends EN1b to EN5b, and the sixth to tenth right ends EN1c to EN5c may have a semi-oval profile (e.g., when viewed in a plan view). Each of the first to fifth right ends EN1a to EN5a, the first to fifth left ends EN1b to EN5b, and the sixth to tenth right ends EN1c to EN5c may have a curvature. The curvature of each of the first to fifth right ends EN1a to EN5a, the first to fifth left ends EN1b to EN5b, and the sixth to tenth right ends EN1c to EN5c may be different from curvatures of inner sidewalls RSW of the first and second separated interconnection lines MI3a_1 and MI3a_2 of FIG. 4. The curvatures of the inner sidewalls RSW of the first and second separated interconnection lines MI3a_1 and MI3a_2 may be greater than the end portions of the first to fifth right ends EN1a to EN5a, the end portions of the first to fifth left ends EN1b to EN5b, and the end portions of the sixth to tenth right ends EN1c to EN5c.

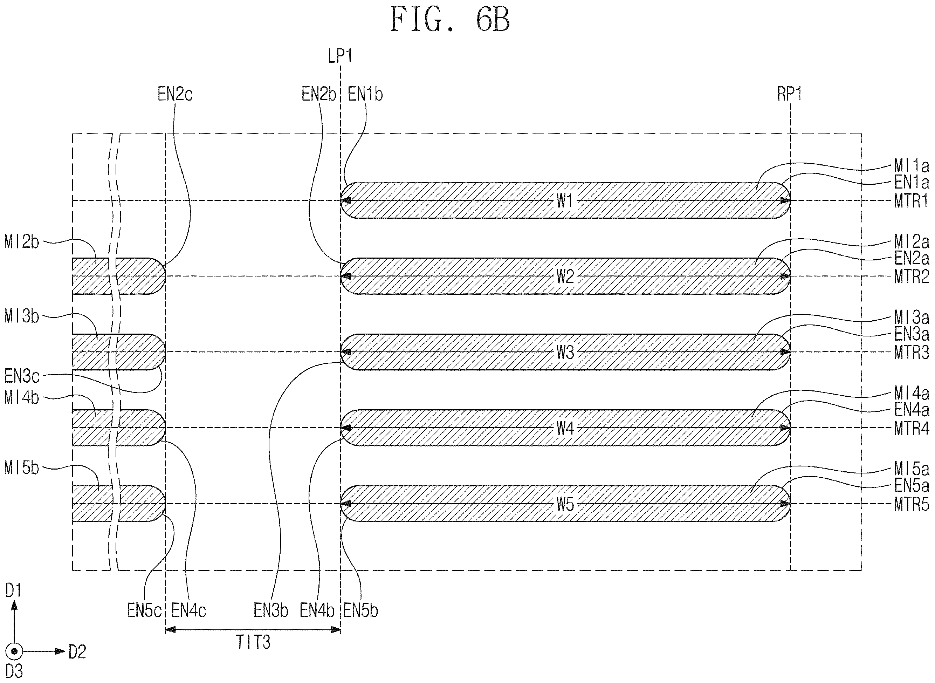

FIG. 6B is a plan view illustrating a comparative example of FIG. 6A. Referring to FIG. 6B, all of the first to fifth right interconnection lines MI1a to MI5a may have the same length (e.g., in the second direction D2). The first to fifth lengths W1 to W5 of FIG. 6B may be smaller than the second and fourth lengths W2 and W4 of FIG. 6A. The first to fifth right ends EN1a to EN5a may be placed on the first right position RP1. The first to fifth left ends EN1b to EN5b may be placed on the first left position LP1.

Distances from the seventh to tenth right ends EN2c to EN5c to the first to fifth left ends EN1b to EN5b may have substantially the same value (e.g., a third distance TIT3). The third distance TIT3 may be larger than the first distance TIT1 of FIG. 6A.

In some embodiments, a first additional interconnection line and a second additional interconnection line may be respectively interposed between the second right interconnection line MI2a and the third right interconnection line MI3a and between the fourth right interconnection line MI4a and the fifth right interconnection line MI5a. The first and second additional interconnection lines may be configured to have substantially the same features as the first right interconnection line MI1a, the third right interconnection line MI3a, and the fifth right interconnection line MI5a. In other embodiments, since the lower interconnection lines are separately formed through three different processes, at least one of three interconnection lines, which are adjacent to each other, may have a length that is longer than the remaining ones of the interconnection lines.

According to the comparative example of FIG. 6B, when the lower interconnection lines are formed using a multi patterning technique (MPT), all of the lower interconnection lines may be formed to have the same length. In this case, the distance (i.e., the third distance TIT3) of the interconnection lines in the first and second logic cell LC1 and LC2 may be larger than or equal to 20 nm.

On the other hand, as shown in FIG. 6A, the lengths of the interconnection lines of the first metal layer M1 may increase and decrease in an alternating manner in some embodiments. Accordingly, the first distance TIT1 between adjacent ones of the interconnection lines may range from 12 nm to 18 nm. In this case, it may be possible to minimize a distance between metal lines in the first metal layer M1 and consequently to increase an integration density of the semiconductor device. As a result, the electrical characteristics of the semiconductor device may be improved.

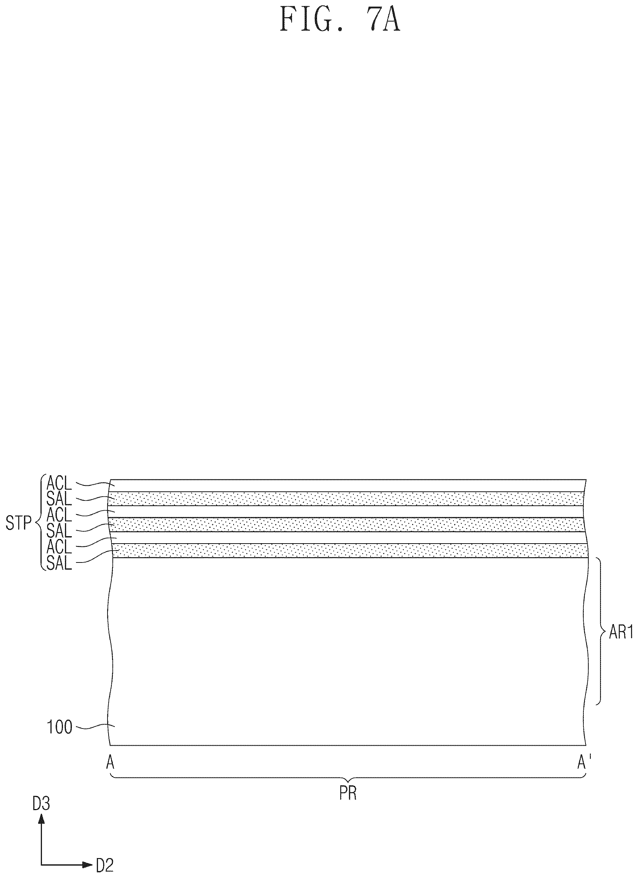

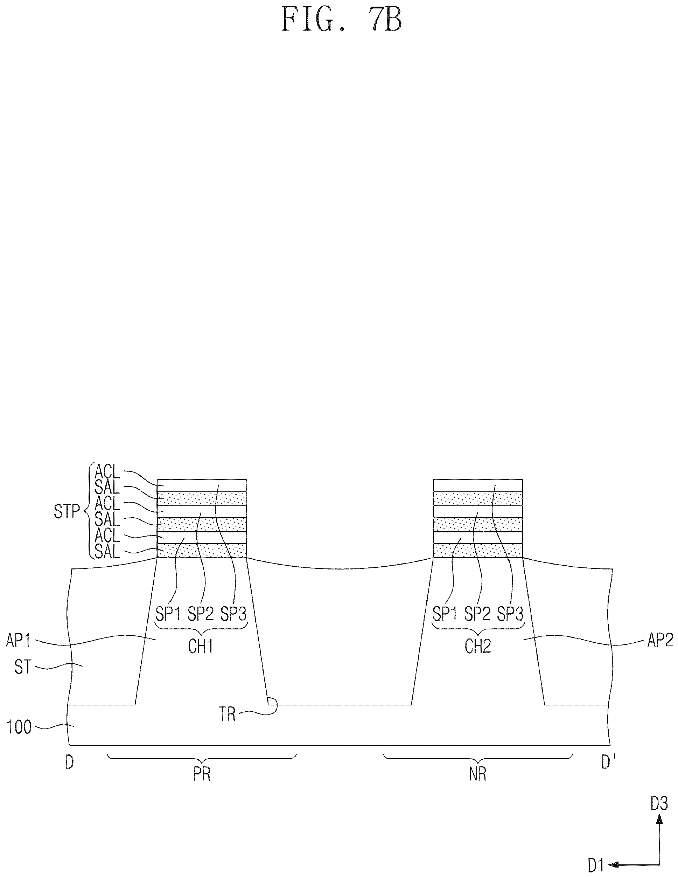

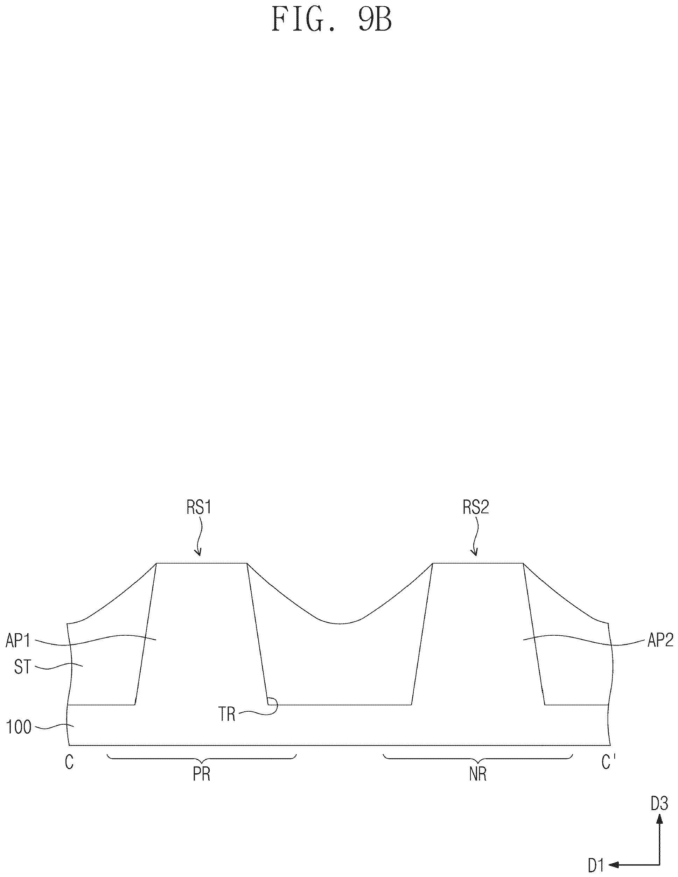

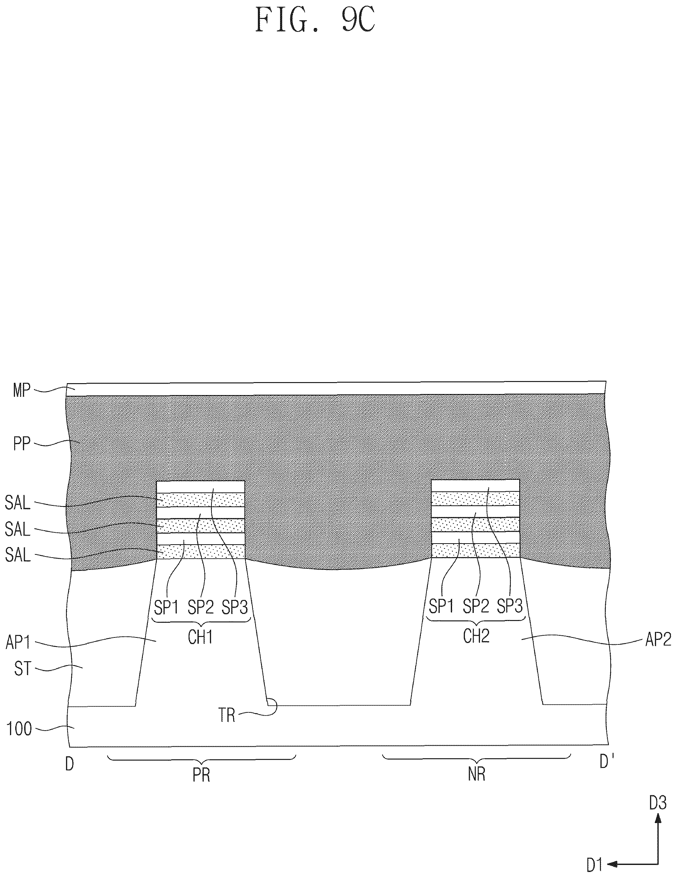

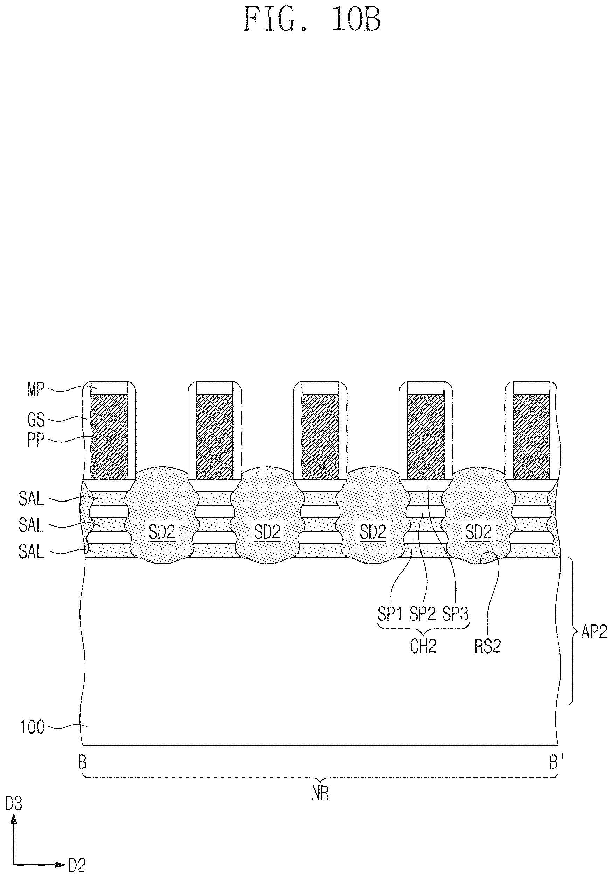

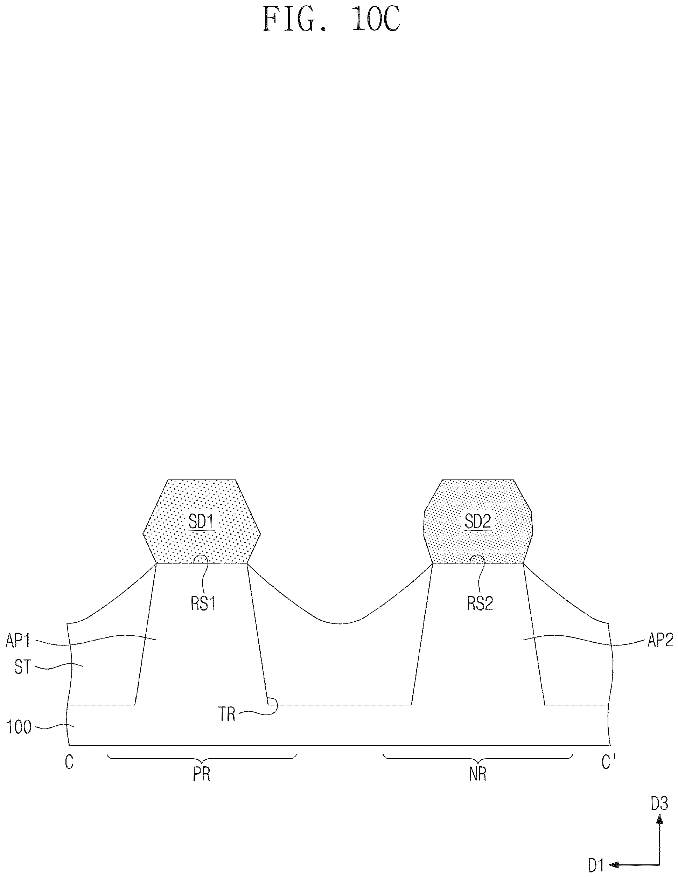

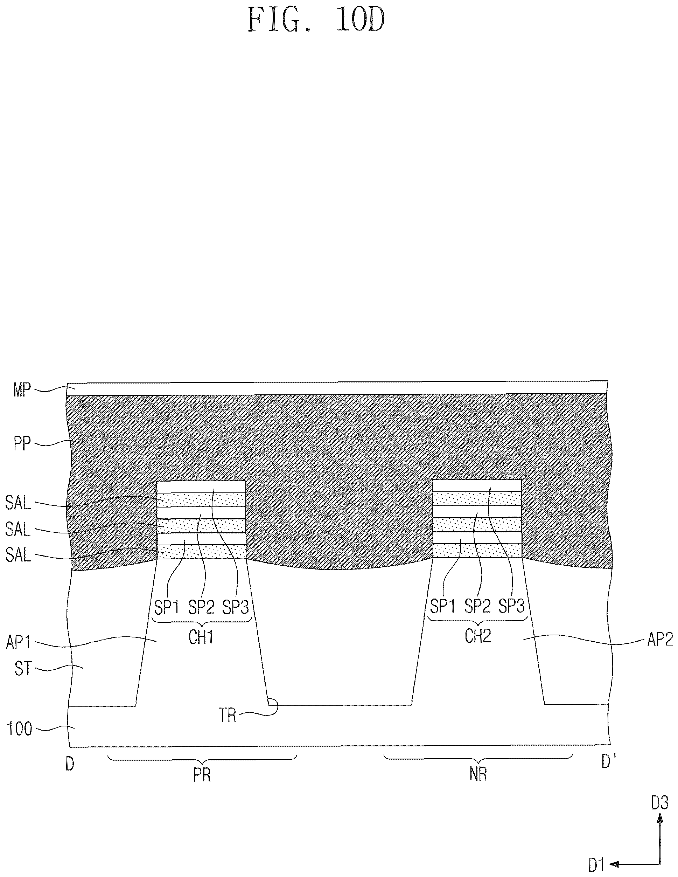

FIGS. 7A to 12C are sectional views illustrating a method of fabricating a semiconductor device, according to some embodiments of the inventive concepts. In detail, FIGS. 7A, 8A, 9A, 10A, 11A, and 12A are sectional views corresponding to the line A-A' of FIG. 4. FIG. 10B is a sectional view corresponding to the line B-B' of FIG. 4. FIGS. 9B, 10C, 11B, and 12B are sectional views corresponding to the line C-C' of FIG. 4. FIGS. 7B, 8B, 9C, 10D, 11C, and 12C are sectional views corresponding to the line D-D' of FIG. 4.

Referring to FIGS. 7A and 7B, the substrate 100 including the PMOSFET region PR and the NMOSFET region NR may be provided. Active and sacrificial layers ACL and SAL may be alternately stacked on the substrate 100. The active and sacrificial layers ACL and SAL may be formed of or include at least one of silicon (Si), germanium (Ge), or silicon-germanium (SiGe), and here, the active and sacrificial layers ACL and SAL may be formed of different materials from each other.

The sacrificial layer SAL may be formed of or include at least one of materials having an etch selectivity with respect to the active layer ACL. For example, the active layers ACL may be formed of or include silicon (Si), and the sacrificial layers SAL may be formed of or include silicon germanium (SiGe). A germanium concentration of each of the sacrificial layers SAL may range from 10 at% to 30 at%.

Mask patterns may be respectively formed on the PMOSFET and NMOSFET regions PR and NR of the substrate 100. The mask pattern may be a line- or bar-shaped pattern that extends in the second direction D2.

A patterning process using the mask patterns as an etch mask may be performed to form the trench TR defining the first and second active patterns AP1 and AP2. The first active pattern AP1 may be formed on the PMOSFET region PR. The second active pattern AP2 may be formed on the NMOSFET region NR.

A stacking pattern STP may be formed on each of the first and second active patterns AP1 and AP2. The stacking pattern STP may include the active layers ACL and the sacrificial layers SAL which are alternately stacked. The stacking pattern STP may be formed along with the first and second active patterns AP1 and AP2, during the patterning process.

The device isolation layer ST may be formed to be in (e.g., to fill) the trench TR. In detail, an insulating layer may be formed on the substrate 100 to cover the first and second active patterns AP1 and AP2 and the stacking patterns STP. The device isolation layer ST may be formed by recessing the insulating layer until the stacking patterns STP are exposed.

The device isolation layer ST may be formed of or include at least one of insulating materials (e.g., silicon oxide). The stacking patterns STP may be placed at a level higher than the device isolation layer ST (e.g., relative to a lower surface of the substrate 100) and may be exposed to the outside of the device isolation layer ST. In other words, the stacking patterns STP may protrude vertically above the device isolation layer ST (e.g., in the third direction D3).

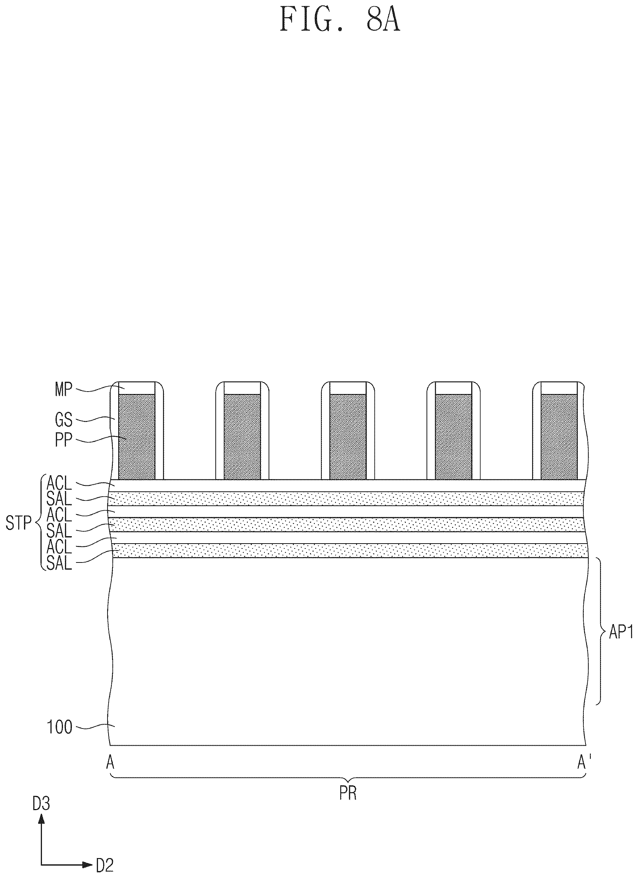

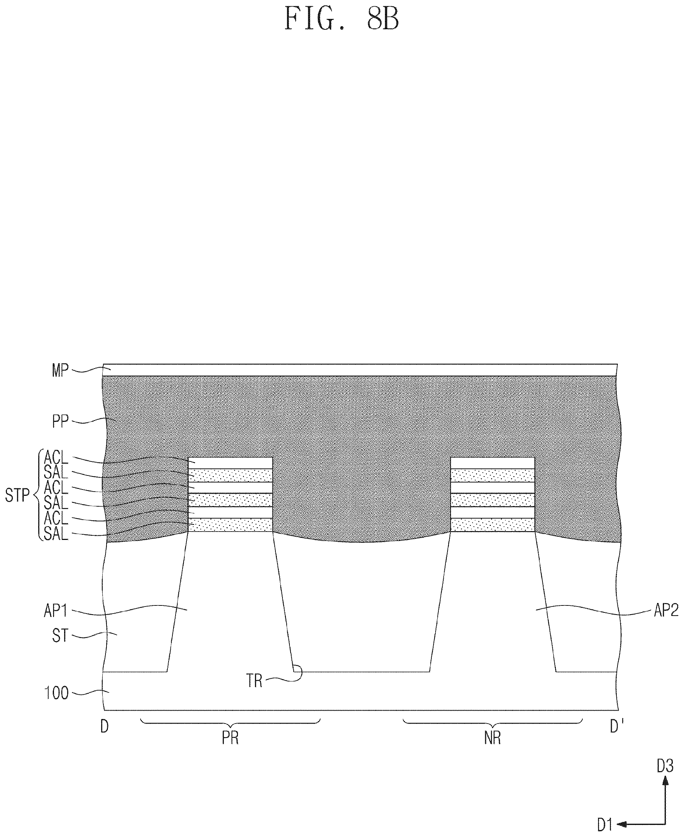

Referring to FIGS. 8A and 8B, sacrificial patterns PP may be formed on the substrate 100 to cross the stacking patterns STP. Each of the sacrificial patterns PP may be a line- or bar-shaped pattern that extends in the first direction D1. The sacrificial patterns PP may be arranged at a first pitch in the second direction D2.

In detail, the formation of the sacrificial patterns PP may include forming a sacrificial layer on the substrate 100, forming hard mask patterns MP on the sacrificial layer, and patterning the sacrificial layer using the hard mask patterns MP as an etch mask. The sacrificial layer may be formed of or include polysilicon.

A pair of the gate spacers GS may be formed on opposite side surfaces of each of the sacrificial patterns PP. The formation of the gate spacers GS may include conformally forming a gate spacer layer on the substrate 100 and anisotropically etching the gate spacer layer. In some embodiments, the gate spacer GS may be a multi-layered structure including at least two layers.

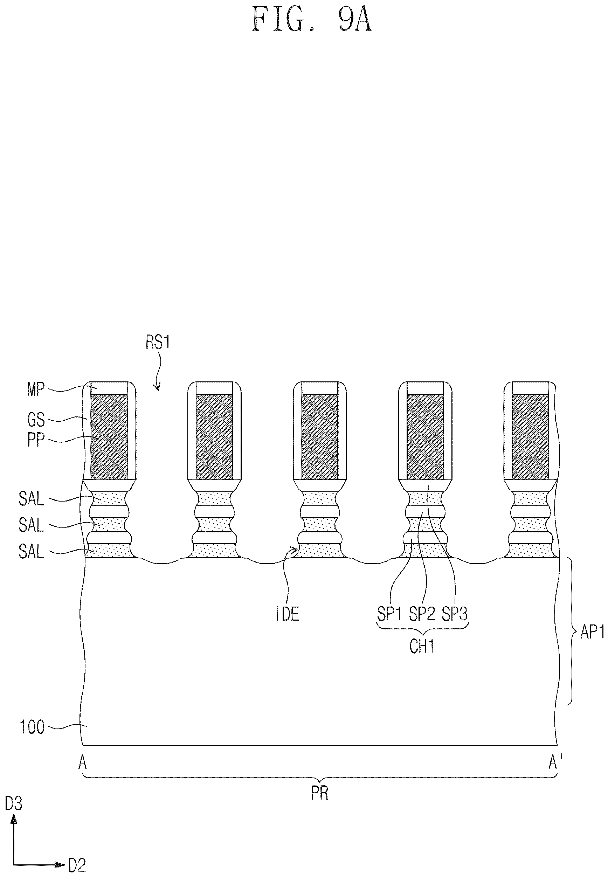

Referring to FIGS. 9A to 9C, the first recesses RS1 may be formed in the stacking pattern STP on the first active pattern AP1. The second recesses RS2 may be formed in the stacking pattern STP on the second active pattern AP2. During the formation of the first and second recesses RS1 and RS2, the device isolation layer ST may also be recessed at both sides of each of the first and second active patterns AP 1 and AP2 (e.g., see FIG. 9B).

In detail, the first recesses RS1 may be formed by etching the stacking pattern STP on the first active pattern AP1, using the hard mask patterns MP and the gate spacers GS as an etch mask. The first recess RS1 may be formed between a pair of the sacrificial patterns PP. The formation of the first recess RS1 may include additionally performing a selective etching process on exposed portions of the sacrificial layers SAL. Each of the sacrificial layers SAL may be indented by the selective etching process to form an indent region IDE. Accordingly, the first recess RS1 may be formed to have an inner side surface of a wavy shape. The second recesses RS2 in the stacking pattern STP on the second active pattern AP2 may be formed by the same method as that for the first recesses RS1.

The first to third semiconductor patterns SP1, SP2, and SP3, which are sequentially stacked on a region between adjacent ones of the first recesses RS1, may be formed from the active layers ACL, respectively. The first to third semiconductor patterns SP1, SP2, and SP3 between adjacent ones of the first recesses RS1 may constitute the first channel pattern CH1. The first to third semiconductor patterns SP1, SP2, and SP3 between the adjacent ones of the second recesses RS2 may constitute the second channel pattern CH2.

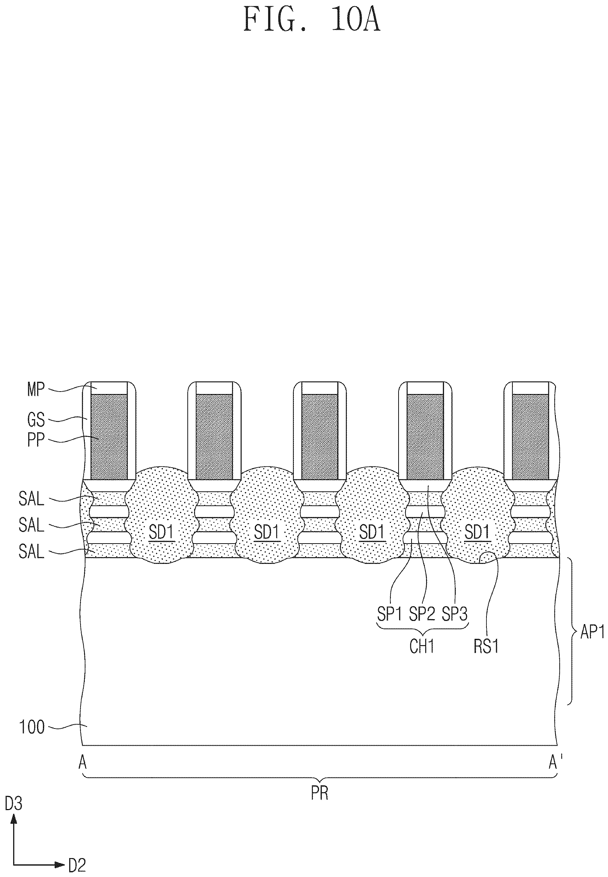

Referring to FIGS. 10A to 10D, the first source/drain patterns SD1 may be formed in the first recesses RS1, respectively. In detail, a SEG process, in which an inner surface of the first recess RS1 is used as a seed layer, may be performed to form an epitaxial layer in (e.g., filling) the first recess RS1. The epitaxial layer may be grown using the first to third semiconductor patterns SP1, SP2, and SP3 and the substrate 100, which are exposed by the first recess RS1, as the seed layer. In some embodiments, the SEG process may include a chemical vapor deposition (CVD) process or a molecular beam epitaxy (MBE) process.

In some embodiments, the first source/drain pattern SD1 may be formed of or include a semiconductor material (e.g., SiGe) whose lattice constant is greater than that of a semiconductor material of the substrate 100. During the formation of the first source/drain pattern SD1, the first source/drain pattern SD1 may be doped in-situ with p-type impurities (e.g., boron, gallium, or indium). In other embodiments, impurities may be injected into the first source/drain pattern SD1, after the formation of the first source/drain pattern SD1.

The second source/drain patterns SD2 may be formed in the second recesses RS2, respectively. In detail, the second source/drain pattern SD2 may be formed by a SEG process using an inner surface of the second recess RS2 as a seed layer.

In some embodiments, the second source/drain pattern SD2 may be formed of or include the same semiconductor element (e.g., Si) as the substrate 100. During the formation of the second source/drain pattern SD2, the second source/drain pattern SD2 may be doped in-situ with n-type impurities (e.g., phosphorus, arsenic, or antimony). In other embodiments, impurities may be injected into the second source/drain pattern SD2, after the formation of the second source/drain pattern SD2.

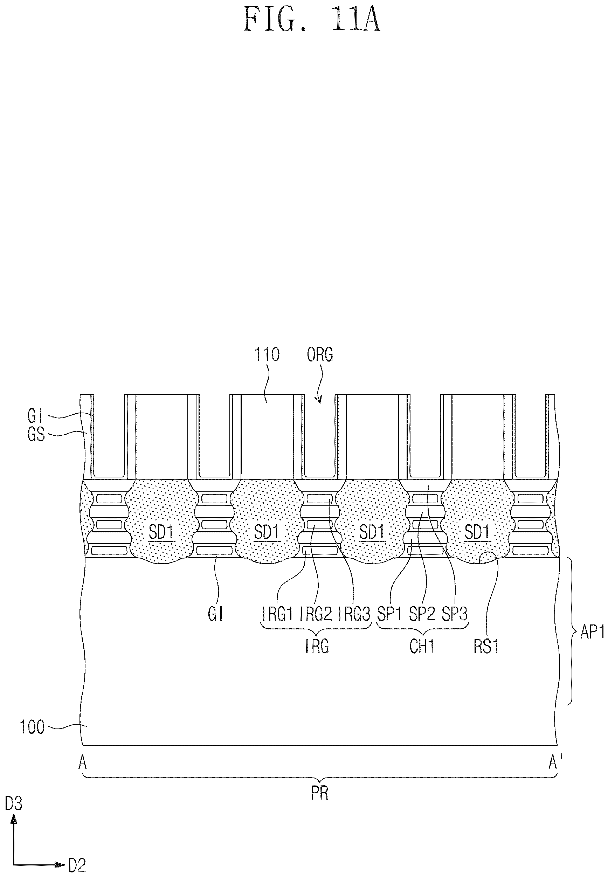

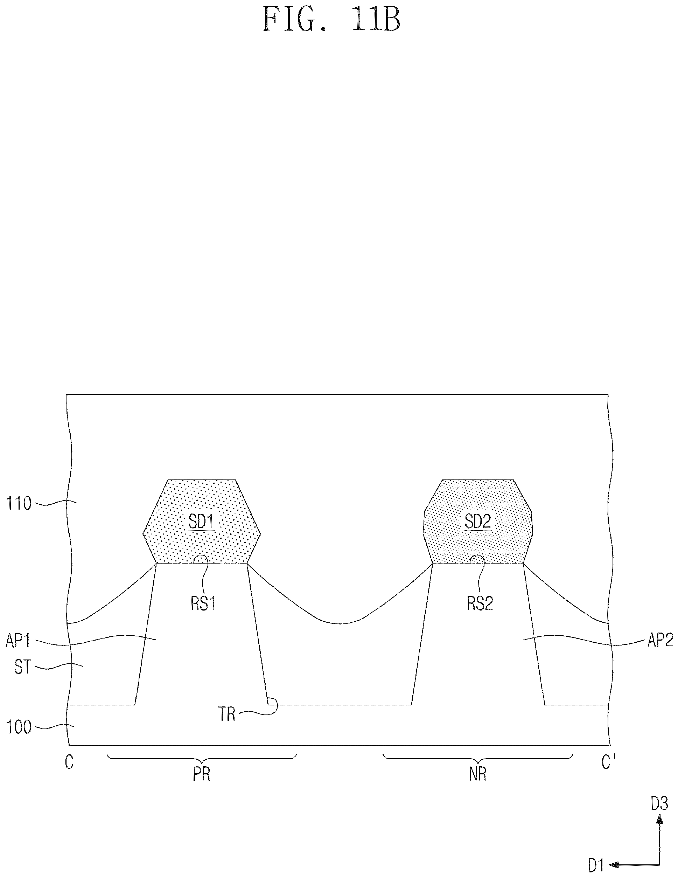

Referring to FIGS. 11A to 11C, the first interlayer insulating layer 110 may be formed to be on (e.g., to cover) the first and second source/drain patterns SD1 and SD2, the hard mask patterns MP, and the gate spacers GS. In some embodiments, the first interlayer insulating layer 110 may include a silicon oxide layer.

The first interlayer insulating layer 110 may be planarized to expose the top surfaces of the sacrificial patterns PP. The planarization of the first interlayer insulating layer 110 may be performed using an etch-back or chemical-mechanical polishing (CMP) process. All the hard mask patterns MP may be removed during the planarization process. As a result, the first interlayer insulating layer 110 may be formed to have a top surface that is coplanar with the top surfaces of the sacrificial patterns PP and the top surfaces of the gate spacers GS.

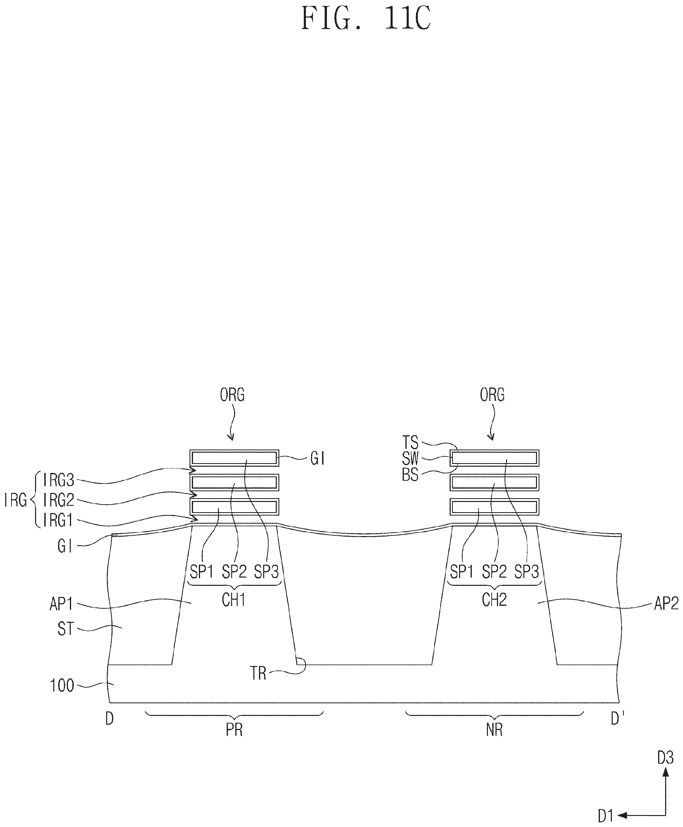

In some embodiments, the exposed sacrificial patterns PP may be selectively removed. As a result of the removal of the sacrificial patterns PP, an outer region ORG exposing the first and second channel patterns CH1 and CH2 may be formed (e.g., see FIG. 11C). The removal of the sacrificial patterns PP may include a wet etching process which is performed using an etching solution capable of selectively etching polysilicon.

The sacrificial layers SAL, which are exposed through the outer region ORG, may be selectively removed to form inner regions IRG (e.g., see FIG. 11C). In detail, a process of selectively etching the sacrificial layers SAL may be performed to leave the first to third semiconductor patterns SP1, SP2, and SP3 and to remove only the sacrificial layers SAL. An etch recipe for the etching process may be chosen to etch a layer (e.g., a silicon germanium layer), which is formed to have a relatively high germanium concentration, at a high etch rate. For example, the etching process may be chosen to have a high etch rate to a silicon germanium layer whose germanium concentration is higher than 10 at%.

During the etching process, the sacrificial layers SAL on the PMOSFET and NMOSFET regions PR and NR may be removed. The etching process may be a wet etching process. An etchant material, which is used in the etching process, may be chosen to quickly remove the sacrificial layer SAL having a relatively high germanium concentration.

Referring to FIG. 11C, since the sacrificial layers SAL are selectively removed, only the first to third semiconductor patterns SP1, SP2, and SP3, which are stacked on each of the first and second active patterns AP1 and AP2, may be left. Empty regions, which are formed by removing the sacrificial layers SAL, may form first to third inner regions IRG1, IRG2, and IRG3, respectively.

In detail, the first inner region IRG1 may be formed between the active pattern AP1 or AP2 and the first semiconductor pattern SP1, the second inner region IRG2 may be formed between the first semiconductor pattern SP1 and the second semiconductor pattern SP2, and the third inner region IRG3 may be formed between the second semiconductor pattern SP2 and the third semiconductor pattern SP3.

Referring to FIGS. 11A to 11C, the gate insulating layer GI may be formed to be on (e.g., to cover) exposed surfaces of the first to third semiconductor patterns SP1, SP2, and SP3. The gate insulating layer GI may be formed to surround each of the first to third semiconductor patterns SP1, SP2, and SP3. The gate insulating layer GI may be formed in each of the first to third inner regions IRG1, IRG2, and IRG3. The gate insulating layer GI may be formed in the outer region ORG.

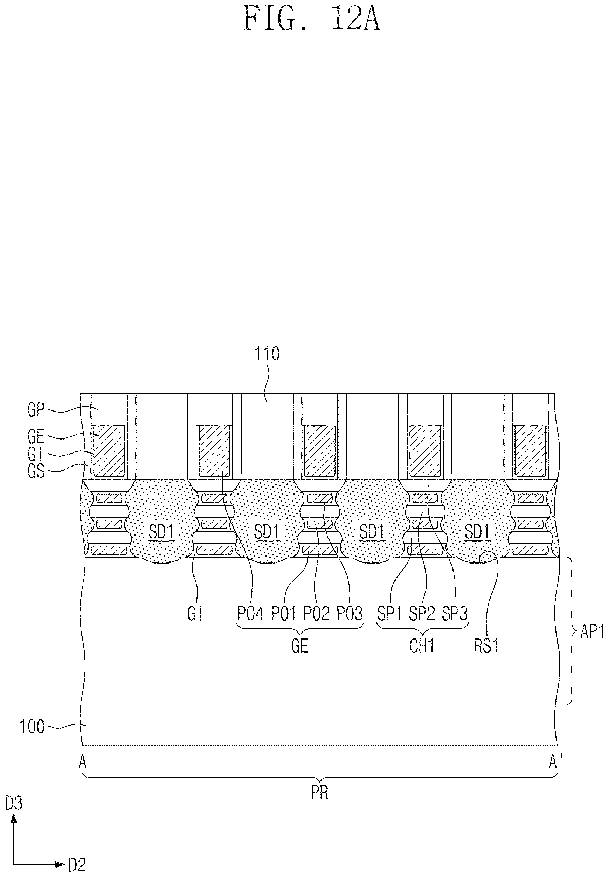

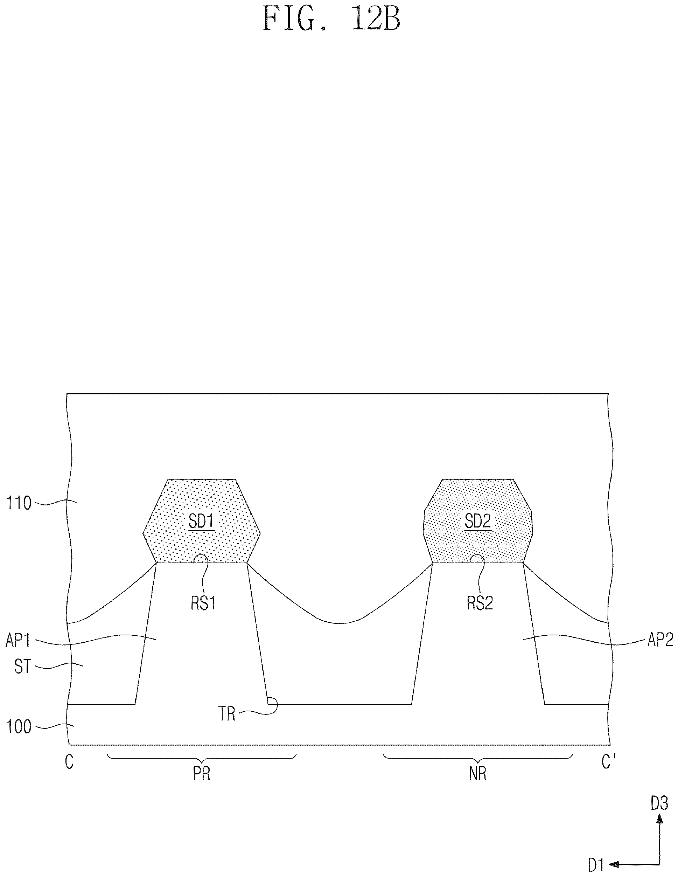

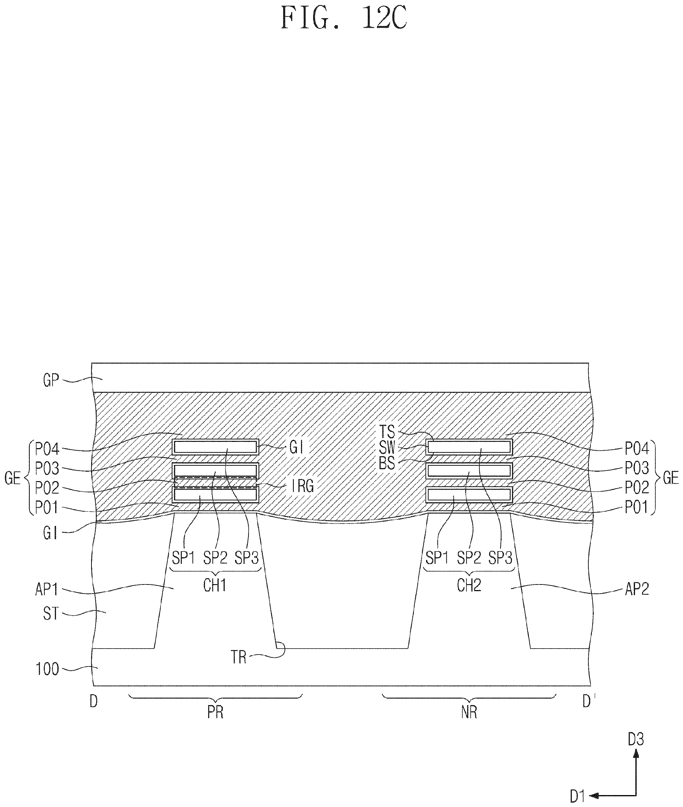

Referring to FIGS. 12A to 12C, the gate electrode GE may be formed on the gate insulating layer GI. The gate electrode GE may include the first, second, and third portions PO1, PO2, and PO3, which are formed in the first, second, and third inner regions IRG1, IRG2, and IRG3, respectively, and the fourth portion PO4, which is formed in the outer region ORG. The gate electrode GE may be vertically recessed to have a reduced height. The gate capping pattern GP may be formed on the recessed gate electrode GE.

Referring back to FIGS. 5A to 5D, the second interlayer insulating layer 120 may be formed on the first interlayer insulating layer 110. The second interlayer insulating layer 120 may include a silicon oxide layer. The active contacts AC may be formed to penetrate the second interlayer insulating layer 120 and the first interlayer insulating layer 110 and may be electrically connected to the first and second source/drain patterns SD1 and SD2. The gate contact GC may be formed to penetrate the second interlayer insulating layer 120 and the gate capping pattern GP and may be electrically connected to the gate electrode GE.

The formation of each of the active and gate contacts AC and GC may include forming the barrier pattern BM and forming the conductive pattern FM on the barrier pattern BM. The barrier pattern BM may be conformally formed and may include a metal layer and a metal nitride layer. The conductive pattern FM may be formed of or include a low resistance metallic material.

The division structures DB may be respectively formed on the borders of the first and second logic cells LC1 and LC2, each of which may be a single height cell SHC in some embodiments (e.g., see FIGS. 1 and 4). The division structure DB may penetrate the second interlayer insulating layer 120 and the gate electrode GE and may extend into the active pattern AP1 or AP2. The division structure DB may include an insulating material (e.g., silicon oxide or silicon nitride).

The third interlayer insulating layer 130 may be formed on the active contacts AC and the gate contacts GC. The first metal layer M1 may be formed in the third interlayer insulating layer 130. The fourth interlayer insulating layer 140 may be formed on the third interlayer insulating layer 130. The second metal layer M2 may be formed in the fourth interlayer insulating layer 140.

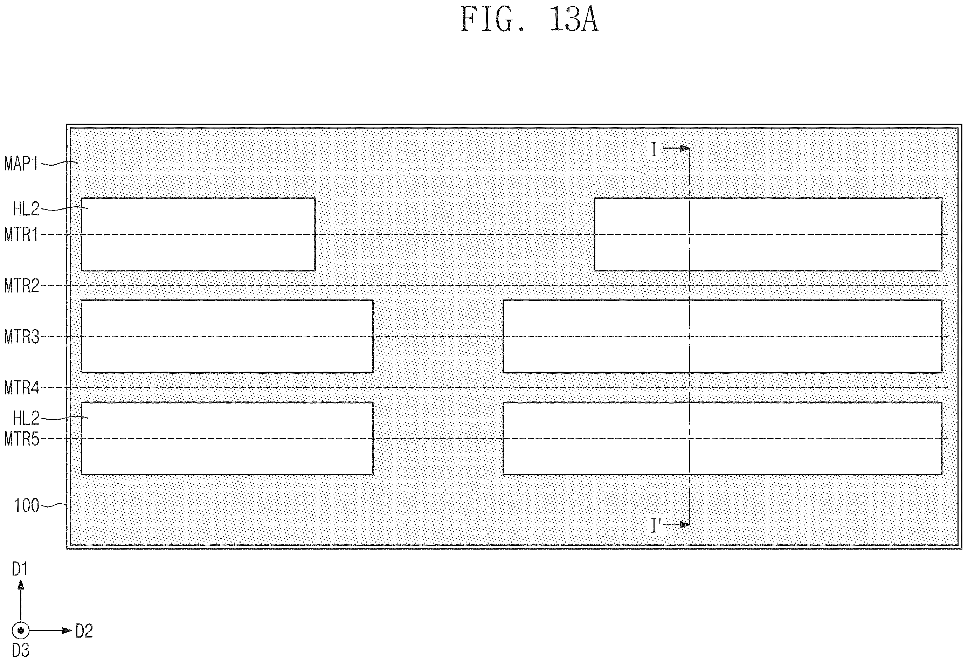

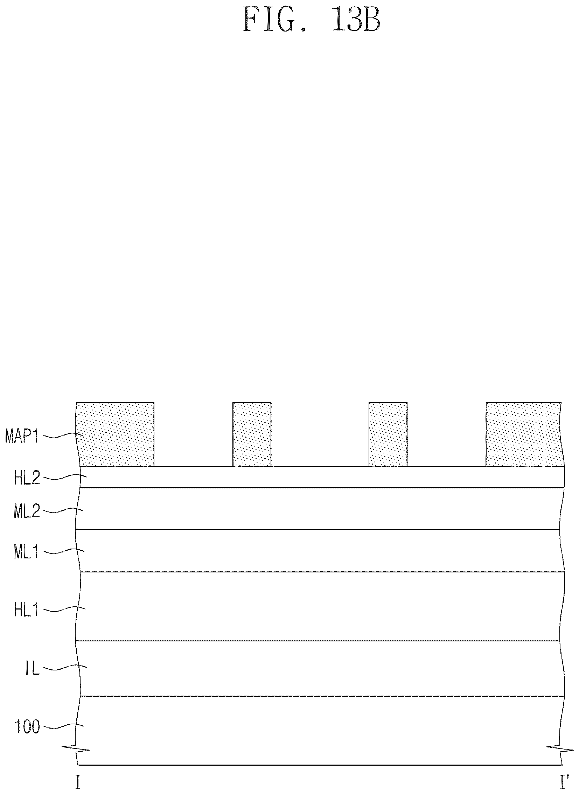

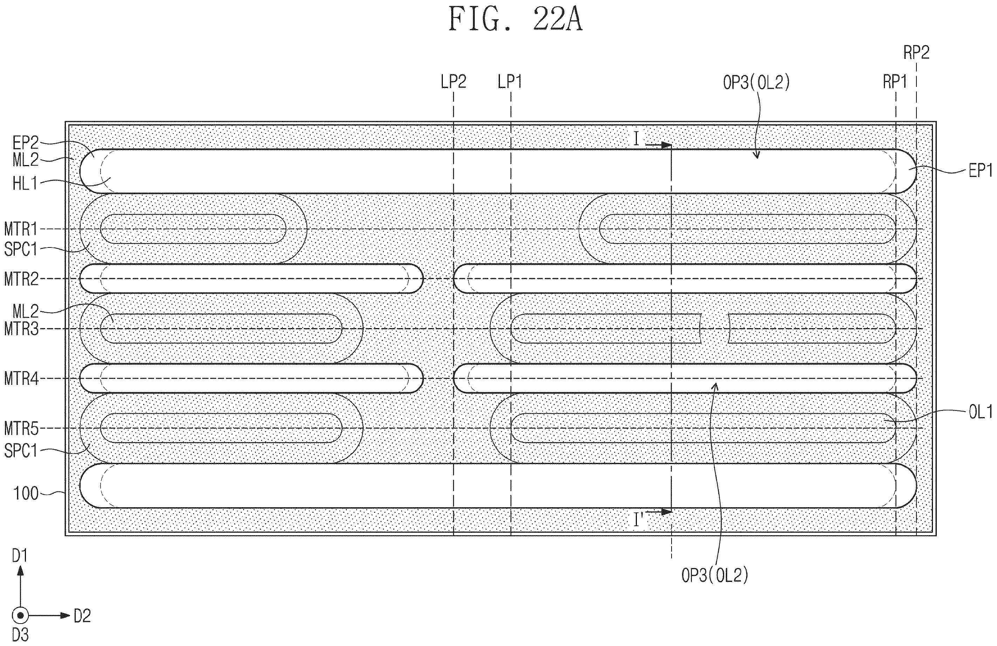

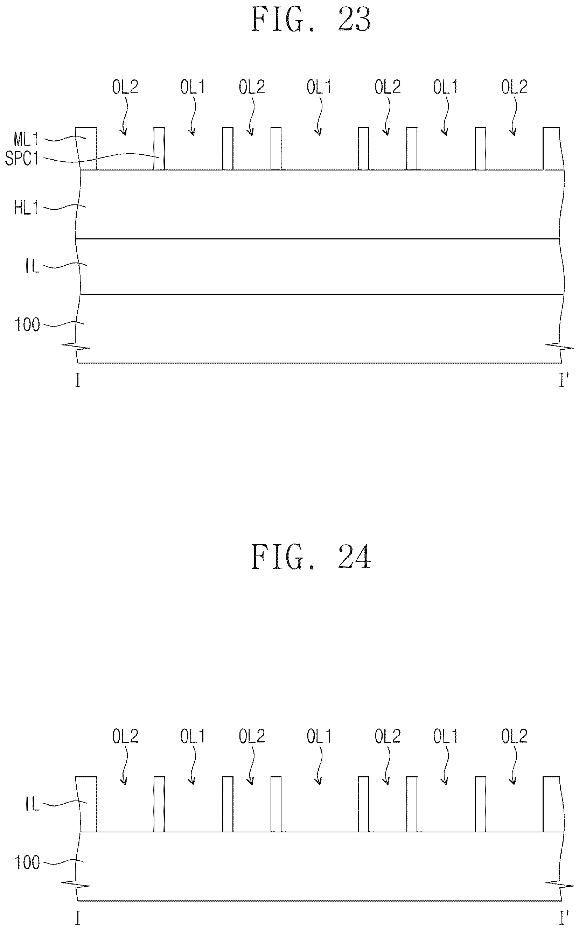

FIGS. 13A to 25B are diagrams illustrating a method of forming the first metal layer M1 of a semiconductor device, according to some embodiments of the inventive concepts. In detail, FIGS. 13A, 14A, 15A, 16A, 17A, 18A, 19A, 22A, and 25A are plan views illustrating a method of fabricating a first metal layer, according to some embodiments of the inventive concepts. FIGS. 13B, 14B, 15B, 16B, 17B, 18B, 19B, 22B, and 25B are sectional views, which are taken along lines I-I' of FIGS. 13A, 14A, 15A, 16A, 17A, 18A, 19A, 22A, and 25A, respectively. FIGS. 23 and 24 are sectional views taken along a line I-I' of FIG. 22A. FIGS. 19C, 20, and 21 are sectional views taken along a line II-II' of FIG. 19A.

Referring to FIGS. 13A and 13B, the logic transistors described with reference to FIGS. 4 and 5A to 5D may be formed on the substrate 100. An interlayer insulating layer II, may be formed on the logic transistors. The interlayer insulating layer II, may correspond to the third interlayer insulating layer 130 of FIGS. 4 and 5A to 5D. A first hard mask layer HL1, a first mold layer ML1, a second mold layer ML2, and a second hard mask layer HL2 may be formed on the interlayer insulating layer IL.

The first hard mask layer HL1 may have an etch selectivity with respect to the interlayer insulating layer IL. The first hard mask layer HL1 may be a single layer or may have a multi-layered structure including a plurality of stacked layers. In some embodiments, a hard mask layer HL may include at least one of a silicon oxide layer, a silicon nitride layer, or a metal nitride layer. For example, the first hard mask layer HL1 may be formed of or include tetraethyl orthosilicate (TEOS).

The first mold layer ML1 may have an etch selectivity with respect to the first hard mask layer HL1. The first and second mold layers ML1 and ML2 may be formed of or include different materials from each other. Each of the first and second mold layers ML1 and ML2 may include at least one of an amorphous silicon layer, an amorphous carbon layer, a spin-on-hardmask (SOH) layer, or a spin-on-carbon (SOC) layer. For example, the first mold layer ML1 may be a silicon layer, and the second mold layer ML2 may be an SOH layer.

The second hard mask layer HL2 may have an etch selectivity with respect to the first mold layer ML1. In some embodiments, the second hard mask layer HL2 may be formed of or include at least one of SiON, SiCN, SiCON, or SiN.

First mask patterns MAP1 may be formed on the second hard mask layer HL2. The first mask patterns MAP 1 may be formed on the second interconnection track MTR2 and the fourth interconnection track MTR4. The first mask patterns MAP1 may be formed at positions corresponding to the first power line M1_R1, the second power line M1_R2, the second right interconnection line MI2a, the fourth right interconnection line MI4a, the second left interconnection line MI2b, and the fourth left interconnection line MI4b previously described with reference to FIG. 4. The first mask patterns MAP1 may not be formed at positions corresponding to the first right interconnection line MI1a, the third right interconnection line MI3a, the fifth right interconnection line MI5a, the first left interconnection line MI1b, the third left interconnection line MI3b, and the fifth left interconnection line MI5b of FIG. 4. The first mask patterns MAP 1 may have an etch selectivity with respect to the second hard mask layer HL2.

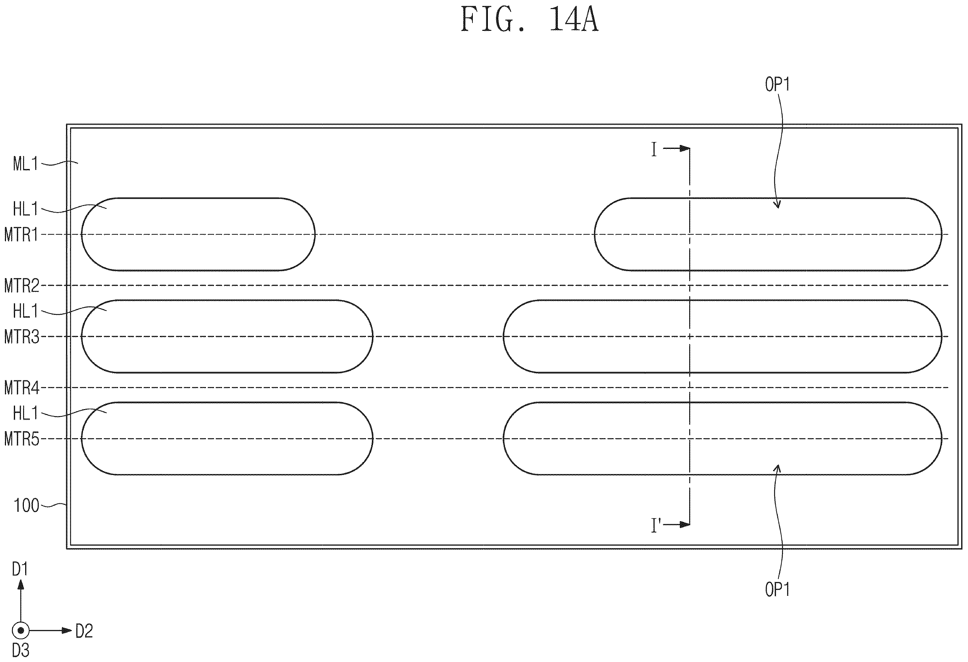

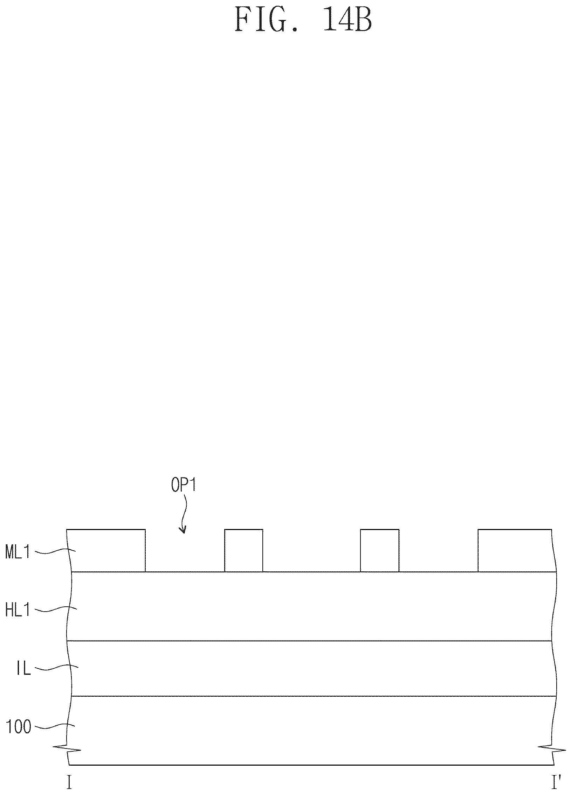

Referring to FIGS. 14A and 14B, the first mold layer ML1 may be etched. Although not specifically shown, the second hard mask layer HL2 and the first and second mold layer ML1 and ML2 may be etched through a patterning process using the first mask patterns MAP1 as an etch mask. Thereafter, the second hard mask layer HL2 and the second mold layer ML2 may be removed.

The first mold layer ML1 may be etched to form a first mold pattern ML1. A plurality of first openings OP1 may be respectively formed between the first mold patterns ML1. The first openings OP1 may be formed to expose a top surface of the first hard mask layer HL1. The first openings OP1 may be formed at positions corresponding to the first right interconnection line MI1a, the third right interconnection line MI3a, the fifth right interconnection line MI5a, the first left interconnection line MI1b, the third left interconnection line MI3b, and the fifth left interconnection line MI5b previously described with reference to FIG. 4. Each of the first openings OP1 may extend in the second direction D2. Inner side surfaces of the first openings OP1 in the second direction D2 may have a semi-oval profile.

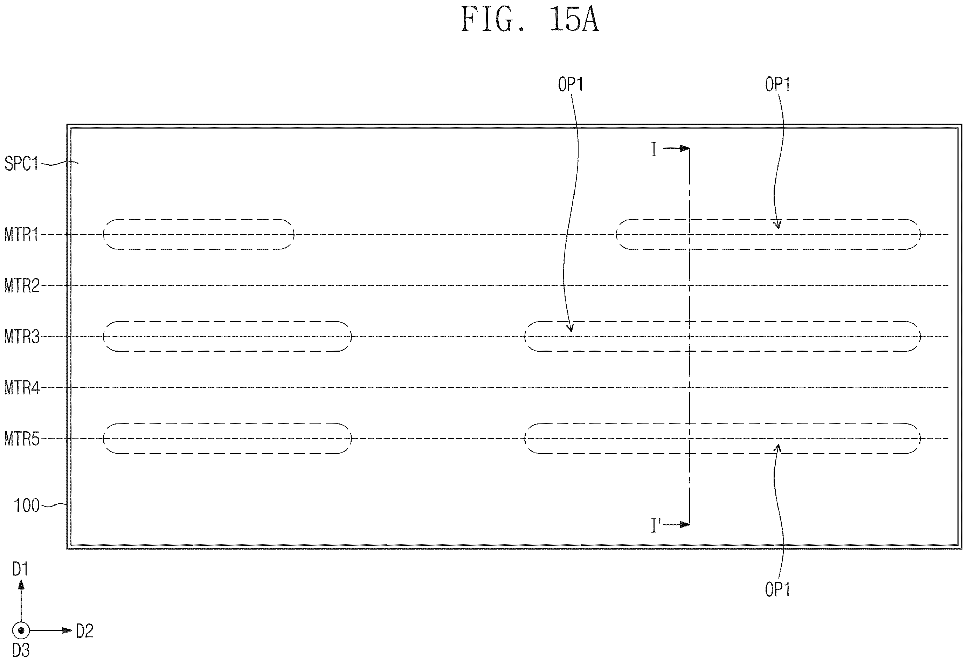

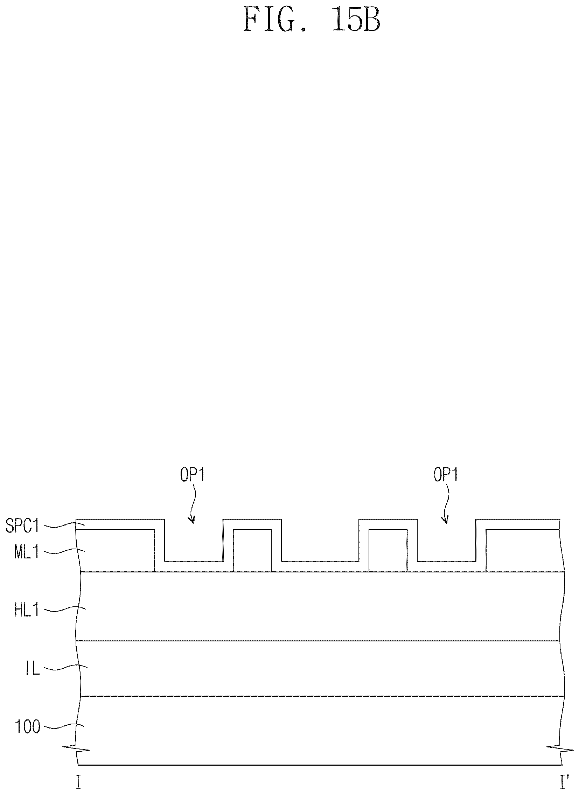

Referring to FIGS. 15A and 15B, a first spacer layer SPC1 may be conformally formed on the first mold pattern ML1 and the first hard mask layer HL1. The first spacer layer SPC 1 may cover the inner side surfaces of the first openings OP 1. The first spacer layer SPC1 may cover a top surface and opposite side surfaces of the first mold pattern ML1. The first spacer layer SPC 1 may cover the top surface of the first hard mask layer HL1 exposed by the first openings OP1. The first spacer layer SPC1 may be formed of or include at least one of TiO, SiCN, SiCON, or SiN.

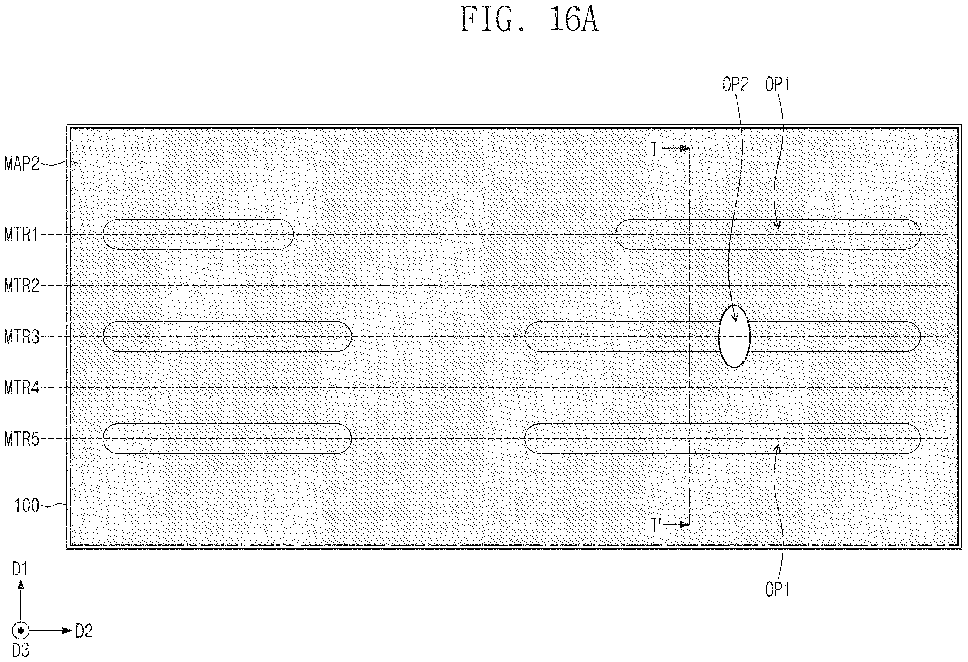

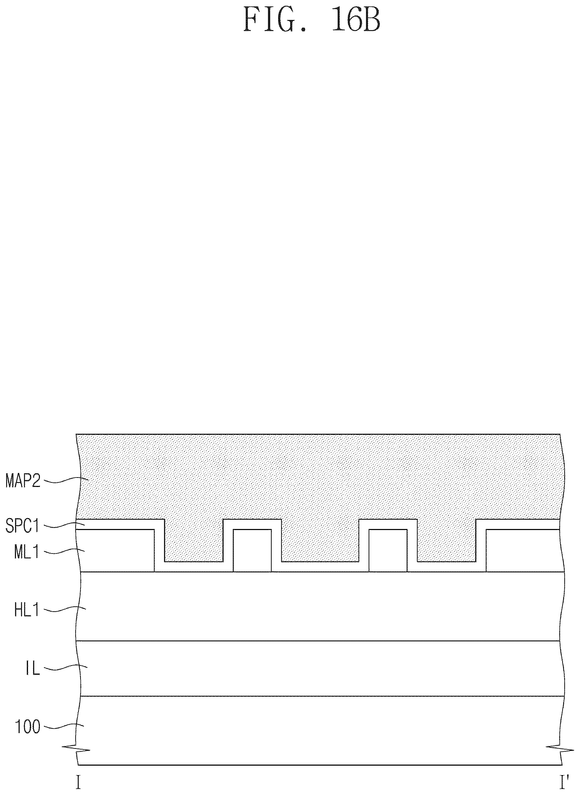

Referring to FIGS. 16A and 16B, a second mask pattern MAP2 may be formed on the first spacer layer SPC1. The second mask pattern MAP2 may include a second opening OP2. The second opening OP2 may have an oval profile. The first spacer layer SPC1 on the first opening OP1 may be exposed through the second opening OP2. The second opening OP2 may be used to divide the third right interconnection line MI3a of FIG. 4 into the first separated interconnection line MI3a_1 and the second separated interconnection line MI3a_2. The formation of the second opening OP2 may include performing a photolithography process on the second mask pattern MAP2. The photolithography process may include an exposure process that is performed using extreme ultraviolet (EUV) as a source light. In some embodiments, the process of FIGS. 16A and 16B may be omitted.

The first opening OP1 exposed by the second opening OP2 may be filled with an insulating material. The first opening OP1 on the third interconnection track MTR3 may be divided into two first openings OP1 by the insulating material.

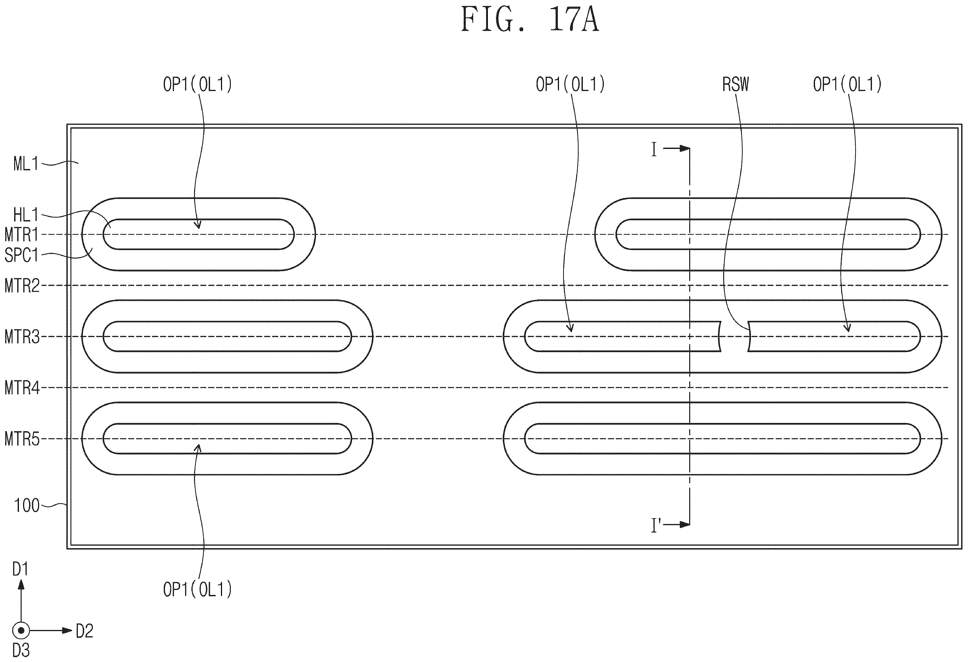

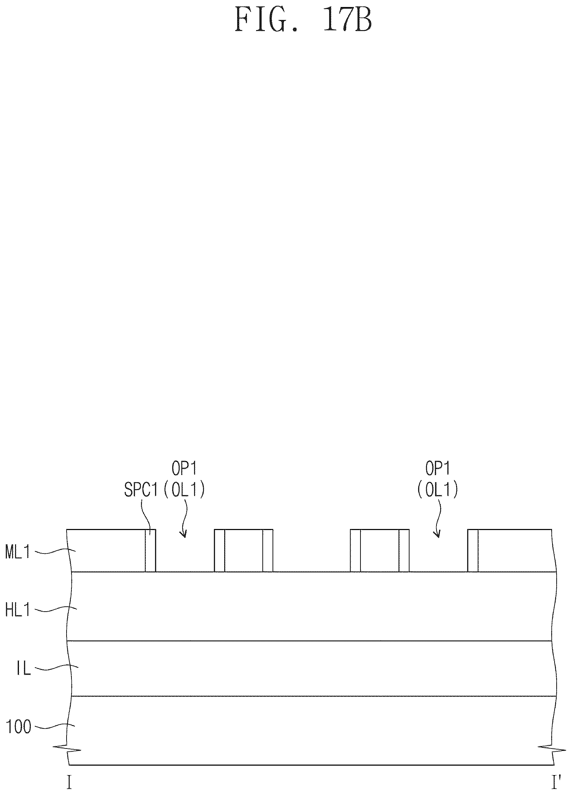

Referring to FIGS. 17A and 17B, the divided first openings OP1 on the third interconnection track MTR3 may have side surfaces RSW that are opposite to each other. Next, the second mask pattern MAP2 may be removed. The first spacer layer SPC1 may be recessed by an etch-back process, until the top surface of the first mold pattern ML1 is exposed. As a result of the recess process, a first spacer SPC1 may be formed on side surfaces of the first mold patterns ML1.

Due to the first mold pattern ML1 and the first spacer SPC1, the first openings OP1 may form first open lines OL1. Each of the first open lines OL1 may be a space defined between the first spacers SPC1.

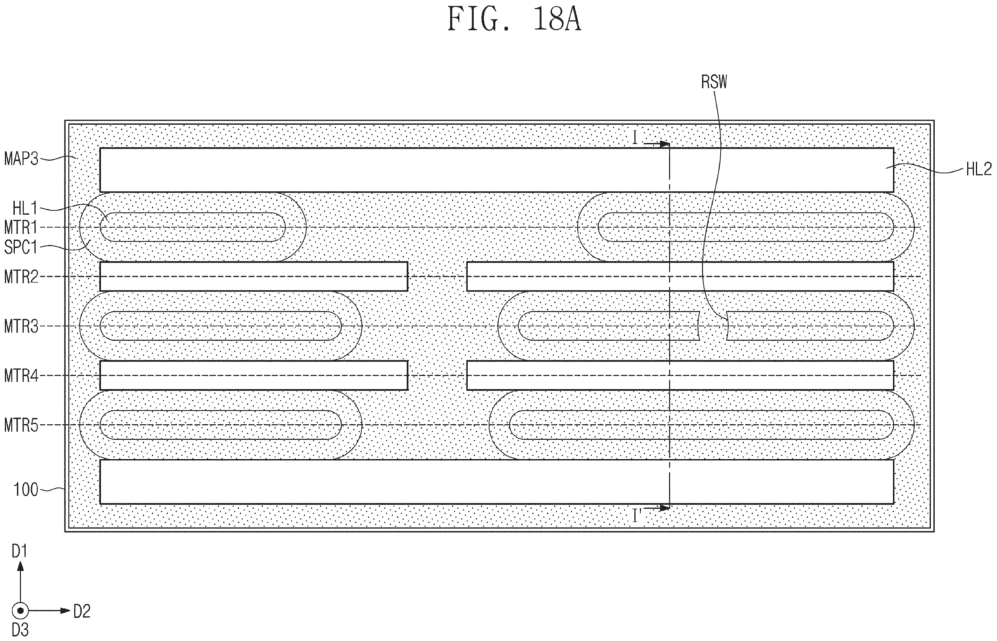

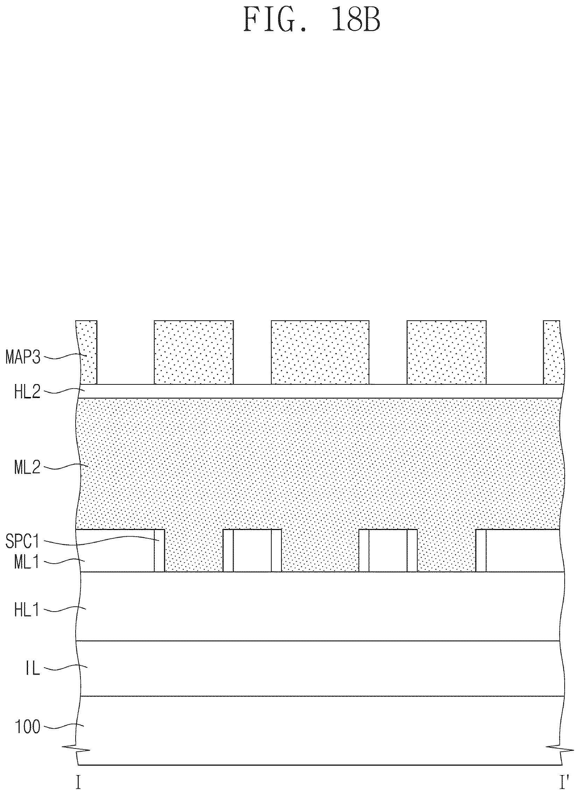

Referring to FIGS. 18A and 18B, the second mold layer ML2 and the second hard mask layer HL2 may be sequentially formed on the first mold pattern ML1 and the first hard mask layer HL1. The second mold layer ML2 and the second hard mask layer HL2 may be formed to have substantially the same features as the second mold layer ML2 and the second hard mask layer HL2 of FIG. 13A, respectively. However, a height of the second mold layer ML2 of FIG. 18B may be larger than the height of the second mold layer ML2 of FIG. 13B (e.g., in the third direction D3).

A third mask pattern MAP3 may be formed on the second hard mask layer HL2. The third mask patterns MAP3 may be formed on the first interconnection track MTR1, the third interconnection track MTR3, and the fifth interconnection track MTR5. The third mask patterns MAP3 may be omitted from regions corresponding to the first and second power lines M1_R1 and M1_R2 previously described with reference to FIG. 4. The third mask patterns MAP3 may be omitted from regions corresponding to the second right interconnection line MI2a, the fourth right interconnection line MI4a, the second left interconnection line MI2b, and the fourth left interconnection line MI4b of FIG. 4. The third mask patterns MAP3 may be vertically overlapped with the first openings OP1.

The third mask patterns MAP3 may be formed of or include the same material as the first mask patterns MAP1. The third mask patterns MAP3 may have an etch selectivity with respect to the second hard mask layer HL2.

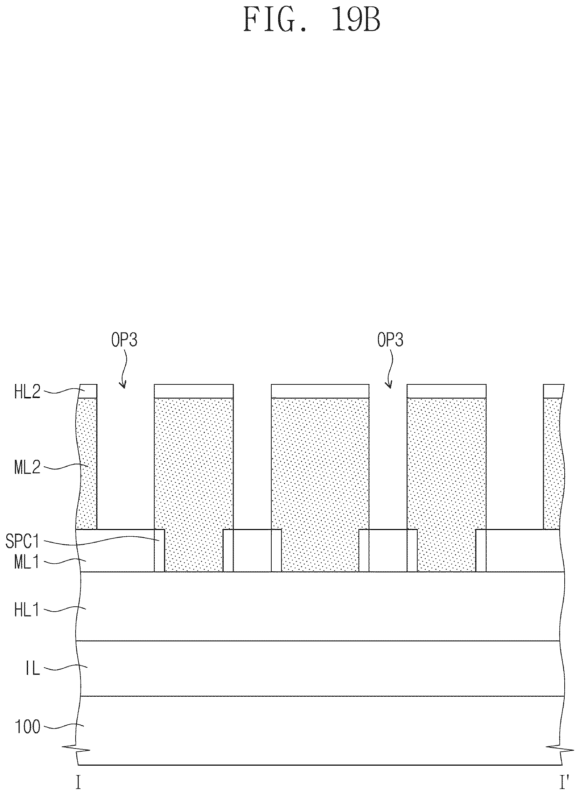

Referring to FIGS. 19A and 19B, the second mold layer ML2 may be etched. In detail, the second hard mask layer HL2 and the second mold layer ML2 may be etched through a patterning process using the third mask patterns MAP3 as an etch mask. Third openings OP3 may be formed in the second mold layer ML2, as a result of the etching of the second mold layer ML2. The third openings OP3 may be formed to expose the top surface of the first mold pattern ML1. In some embodiments, at least one of the third openings OP3 may be formed to expose a portion of a top surface of the first spacer SPC1.

The third openings OP3 may be formed at positions corresponding to the first and second power lines M1_R1 and M1_R2, the second right interconnection line MI2a, the fourth right interconnection line MI4a, the second left interconnection line MI2b, and the fourth left interconnection line MI4b previously described with reference to FIG. 4. Each of the third openings OP3 may extend in the second direction D2. Inner side surfaces of the third openings OP3 in the second direction D2 may have a semi-oval profile.

Referring to FIG. 19C, ones of the third openings OP3 may have a first preliminary width PW1 in the second direction D2. The first preliminary width PW1 may be larger than widths of the third openings OP3 in the first direction D 1.

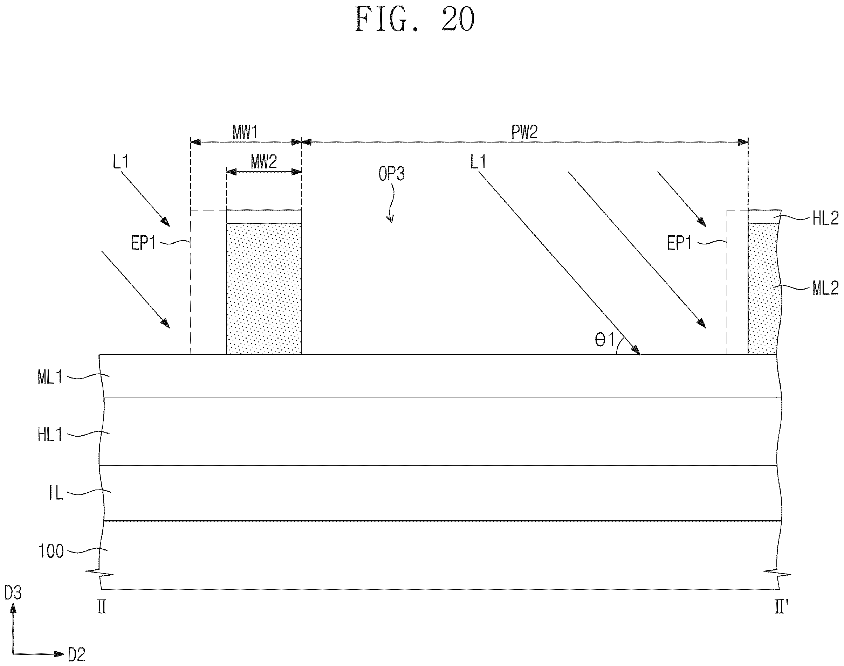

Referring to FIG. 20, the second hard mask layer HL2 and the second mold layer ML2 may be etched by performing an etching process on the third openings OP3 (e.g., a first etching step). The etching process may be an ion beam etching (IBE) process. A first incident beam L1 of energetic ions may be incident toward a top surface of the substrate 100 at a specific angle. The incident angle of the first incident beam L1 may be a first incident angle θ1, which is an acute angle to the second direction D2. The substrate 100 may be tilted to allow for the incidence of the first incident beam L1 at the specific angle.

A sidewall portion EP1 of both the second hard mask layer HL2 and the second mold layer ML2 may be removed by the first incident beam L 1. Accordingly, a width of the second mold layer ML2 in the second direction D2 may decrease from a first mold width MW1 to a second mold width MW2. The first preliminary width PW 1 of the third opening OP3 may be increased to a second preliminary width PW2. The third opening OP3 may be extended in the second direction D2 (e.g., may be elongated in the second direction D2). In other words, the length of the third opening OP3 in the second direction D2 may be increased.

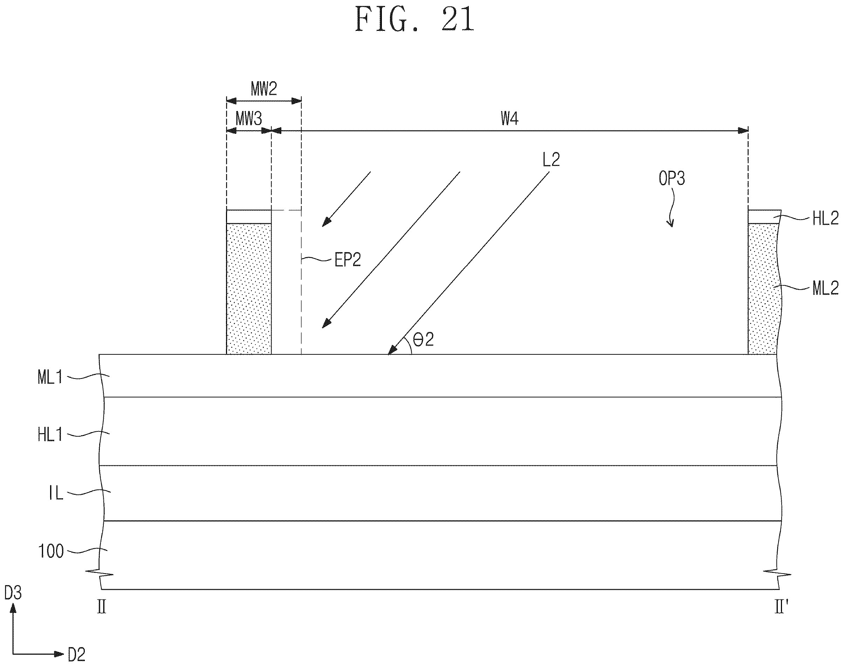

Referring to FIG. 21, the second hard mask layer HL2 and the second mold layer ML2 may be etched once more through an etching process performed on the third openings OP3 (e.g., a second etching step). The etching process may be an ion beam etching (IBE) process. A second incident beam L2 of energetic ions may be incident toward the top surface of the substrate 100 at a specific angle. The incident angle of the second incident beam L2 may be a second incident angle θ2, which is an acute angle to the second direction D2. The substrate 100 may be tilted to allow for the incidence of the second incident beam L2 at the specific angle. The second incident beam L2 may have a different sign from that of the first incident beam L1. Each of the first and second incident angles θ1 and θ2 may range from 10° to 80°, but the inventive concepts are not limited to this example.

An opposite sidewall portion EP2 of both the second hard mask layer HL2 and the second mold layer ML2 may be removed by the second incident beam L2. Accordingly, a width of the second mold layer ML2 in the second direction D2 may decrease from the second mold width MW2 to a third mold width MW3. The second preliminary width PW2 of the third opening OP3 may be increased to the fourth length W4. The third opening OP3 may be extended in the second direction D2 (e.g., may be elongated in the second direction D2). In other words, the length of the third opening OP3 in the second direction D2 may be increased.

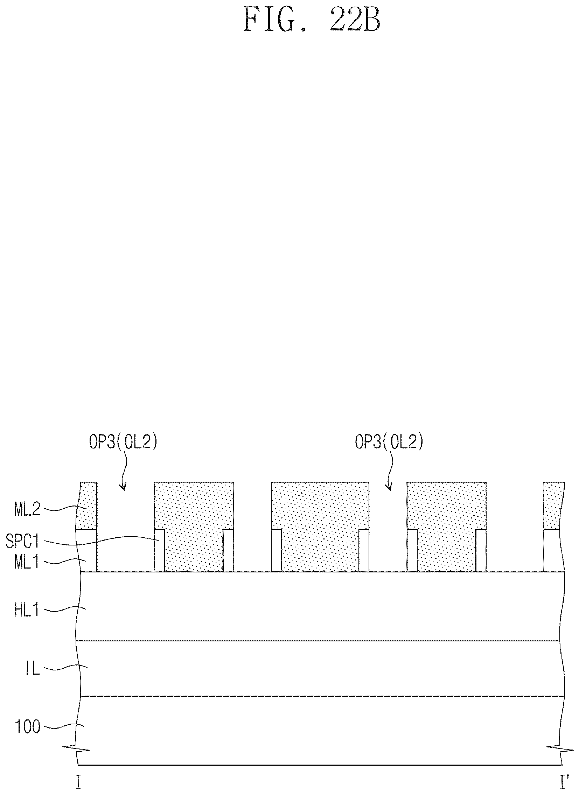

As a result of the etching process of FIGS. 20 and 21, the third openings OP3 may form second open lines that have an increased length (e.g., in the second direction D2). Referring to FIGS. 22A and 22B, the first mold pattern ML1, which is exposed by such a second open line OL2, may be etched. Next, the second hard mask layer HL2 may be removed, and then, an upper portion of the second mold layer ML2 may be etched such that a height of the second mold layer ML2 is reduced (e.g., in the third direction D3).

The second open line OL2 and the first open line OL1 may be alternatingly disposed (i.e., alternately arranged) in the first direction D1 (e.g., see FIGS. 23 and 24). The second open line OL2 may be longer than the first open line OL1 in the second direction D2. An end portion of the second open line OL2 may protrude in the second direction D2, relative to an end portion of the first open line OL1. In other words, an end portion of the second open line OL2 may protrude beyond an end portion of the first open line OL1 in the second direction D2. An opposite end portion of the second open line OL2 may protrude in the second direction D2, relative to an opposite end portion of the first open line OL1. In other words, an opposite end portion of the second open line OL2 may protrude beyond an opposite end portion of the first open line OL1 in the second direction D2.

Each of end portions of the first open line OL1 may be placed on one of the first right position RP1 or the first left position LP1. Each of end portions of the second open line OL2 may be placed on one of the second right position RP2 or the second left position LP2.

Referring to FIG. 23, the second mold layer ML2 may be removed to expose the first spacer SPC1 and the first mold pattern ML1. Since the second mold layer ML2 is removed, both of the first and second open lines OL1 and OL2 may be exposed.

Referring to FIG. 24, the first hard mask layer HL1 and the interlayer insulating layer IL may be etched by performing an etching process using the first spacer SPC1 and the first mold pattern ML1 as an etch mask. The first spacer SPC1, the first mold pattern ML1, and the first hard mask layer HL1 may be removed. For example, the first mold patterns ML1 exposed by the second open lines OL1 may be removed. The first and second open lines OL1 and OL2 may be formed in the interlayer insulating layer IL.

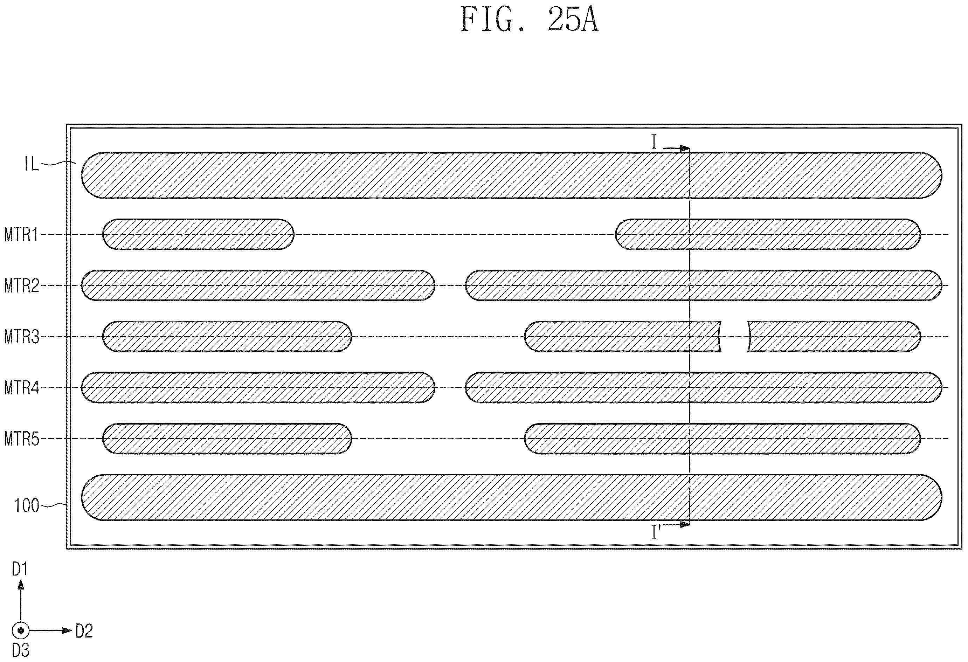

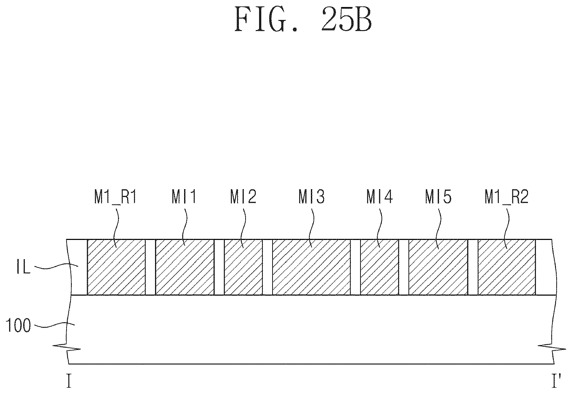

Referring to FIGS. 4, 25A, and 25B, the interconnection lines of the first metal layer M1 may be formed by filling the first and second open lines OL1 and OL2 with a conductive material. In detail, the first right interconnection line MI1a, the third right interconnection line MI3a, the fifth right interconnection line MI5a, the first left interconnection line MI1b, the third left interconnection line MI3b, and the fifth left interconnection line MI5b may be formed by filling the first open lines OL1 with the conductive material. The first and second power lines M1_R1 and M1_R2, the second right interconnection line MI2a, the fourth right interconnection line MI4a, the second left interconnection line MI2b, and the fourth left interconnection line MI4b may be formed by filling the second open lines OL2 with the conductive material.

In some embodiments, third open lines may be additionally formed. The interconnection lines of the first metal layer M1 may be divided by the first to third open lines. The third open lines may be formed to have substantially the same features as the first open lines OL1. The third open lines may have a length that is shorter than the second open lines OL2 (e.g., in the second direction D2). In some embodiments, a fourth open line and a fifth open line may be additionally formed.

FIGS. 26A to 26D are sectional views, which are taken along lines A-A', B-B', C-C', and D-D' of FIG. 4, respectively, to illustrate a semiconductor device according to some embodiments of the inventive concepts. In the following description, an element previously described with reference to FIGS. 4 and 5A to 5D may be identified by the same reference number without repeating an overlapping description thereof, for concise description.

The PMOSFET and NMOSFET regions PR and NR may be defined by a second trench TR2, which is formed in an upper portion of the substrate 100. The second trench TR2 may be located between the PMOSFET and NMOSFET regions PR and NR. The PMOSFET and NMOSFET regions PR and NR may be spaced apart from each other in the first direction D1, with the second trench TR2 interposed therebetween.

The first active patterns AP1 and the second active patterns AP2 may be provided on the PMOSFET region PR and the NMOSFET region NR, respectively. The first and second active patterns AP1 and AP2 may extend in the second direction D2 parallel to each other. The first and second active patterns AP1 and AP2 may be portions of the substrate 100 protruding in a vertical direction (i.e., in the third direction D3). A first trench TR1 may be defined between adjacent ones of the first active patterns AP 1 and between adjacent ones of the second active patterns AP2. The first trench TR1 may be shallower than the second trench TR2.

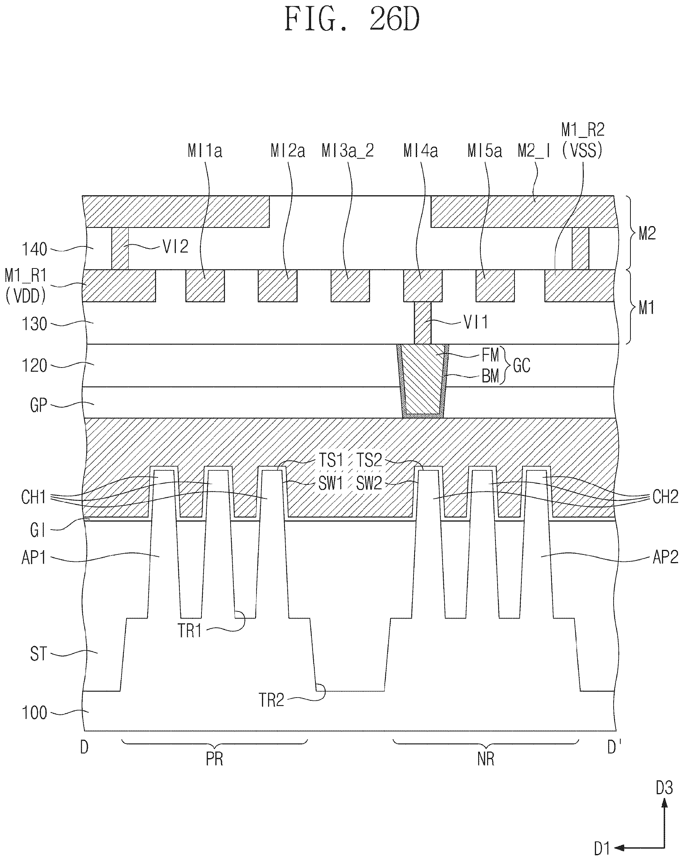

The device isolation layer ST may be provided in (e.g., to fill) the first and second trenches TR1 and TR2. Upper portions of the first and second active patterns AP1 and AP2 may protrude vertically above the device isolation layer ST (e.g., see FIG. 26D). Each of the upper portions of the first and second active patterns AP1 and AP2 may be shaped like a fin. The device isolation layer ST may not be on (e.g., may not cover) the upper portions of the first and second active patterns AP1 and AP2. The device isolation layer ST may be on (e.g., may cover) lower side surfaces of the first and second active patterns AP1 and AP2.

The first source/drain patterns SD1 may be provided in the upper portions of the first active patterns AP1. The first source/drain patterns SD1 may be impurity regions of a first conductivity type (e.g., p-type). The first channel pattern CH1 may be interposed between a pair of the first source/drain patterns SD1. The second source/drain patterns SD2 may be provided in the upper portions of the second active patterns AP2. The second source/drain patterns SD2 may be impurity regions of a second conductivity type (e.g., n-type). The second channel pattern CH2 may be interposed between a pair of the second source/drain patterns SD2. Other features associated with the first and second source/drain patterns SD1 and SD2 may be the same as or similar to those in the embodiments described with reference to FIGS. 4 and 5A to 5D.

The gate electrodes GE may be provided to cross the first and second active patterns AP1 and AP2 and to extend in the first direction D1. The gate electrodes GE may be vertically overlapped with the first and second channel patterns CH1 and CH2. Each of the gate electrodes GE may be provided to face a top surface and opposite side surfaces of each of the first and second channel patterns CH1 and CH2. As shown in FIG. 26D, the gate electrode GE may be provided on a first top surface TS1 of the first channel pattern CH1 and at least one first side surface SW1 of the first channel pattern CH1. The gate electrode GE may be provided on a second top surface TS2 of the second channel pattern CH2 and at least one second side surface SW2 of the second channel pattern CH2. In other words, the transistor according to some embodiments may be a three-dimensional field-effect transistor (e.g., FinFET), in which the gate electrode GE is provided to surround the channel patterns CH1 and CH2 three-dimensionally.

Features associated with the active and gate contacts AC and GC and the first and second metal layers M1 and M2 may be the same as or similar to those in the embodiments described with reference to FIGS. 4 and 5A to 5D.

In a semiconductor device according to some embodiments of the inventive concepts, interconnection lines of a first metal layer may be formed through a multi-patterning technique. An ion beam etching (IBE) process may be performed to reduce a width of an insulating portion in a process of insulating the interconnection lines. In the IBE process, ions may be incident toward a substrate with an incident angle to reduce a length of the insulating portion. Thus, a length of the interconnection lines may be increased. Furthermore, in a method of fabricating a semiconductor device according to some embodiments of the inventive concepts, end portions of the interconnection lines may protrude in an alternating manner. In this case, an integration density of the semiconductor device may be increased. Furthermore, the electrical characteristics of the semiconductor device may be improved.

While example embodiments of the inventive concepts have been particularly shown and described, it will be understood by one of ordinary skill in the art that variations in form and detail may be made therein without departing from the scope of the attached claims.

As used herein, the terms "comprises", "comprising", "includes", "including", "has", "having" and any other variations thereof specify the presence of the stated features, steps, operations, elements, components, and/or groups but do not preclude the presence or addition of one or more other features, steps, operations, elements, components, and/or groups thereof. In addition, it will be understood that, although the terms "first", "second", "third", etc. may be used herein to describe various elements, these elements should not be limited by these terms. Rather, these terms are only used to distinguish one element from another. For example, a first element could be termed a second element, and, similarly, a second element could be termed a first element, without departing from the scope of the present disclosure.

## Claims

1. A semiconductor device, comprising:
a first logic cell and a second logic cell, which are on a substrate and are spaced apart from each other in a first direction, and each of which includes a PMOSFET region and an NMOSFET region; and
a first metal layer on the first logic cell and a second metal layer on the second logic cell,
wherein the first metal layer comprises a first right interconnection line, a second right interconnection line, and a third right interconnection line, which extend in the first direction parallel to each other, with the second right interconnection line between the first right interconnection line and the third right interconnection line,
wherein the second metal layer comprises a first left interconnection line,
wherein the first right interconnection line has a first end facing the first left interconnection line,
wherein the second right interconnection line has a second end facing the second logic cell,
wherein the third right interconnection line has a third end facing the second logic cell,
wherein the first and third ends protrude beyond the second end in the first direction, and
wherein a shortest distance between the first right interconnection line and the first left interconnection line in the first direction is defined as a first distance that is in a range from 12 nm to 18 nm.

2. The semiconductor device of claim 1, wherein the first right interconnection line has a fourth end opposite to the first end,
wherein the second right interconnection line has a fifth end opposite to the second end,
wherein the third right interconnection line has a sixth end opposite to the third end, and
wherein the fourth and sixth ends protrude beyond the fifth end in the first direction.

3. The semiconductor device of claim 1, wherein the first end protrudes beyond the second end by a second distance in the first direction, and
wherein the second distance is in a range from 2 nm to 10 nm.

4. The semiconductor device of claim 1, wherein a length of the second right interconnection line is smaller than a length of the first right interconnection line and a length of the third right interconnection line in the first direction.

5. The semiconductor device of claim 1, wherein the second metal layer further comprises a second left interconnection line and a third left interconnection line, and
wherein a length of the second left interconnection line is smaller than a length of the first left interconnection line and a length of the third left interconnection line in the first direction.

6. The semiconductor device of claim 5, wherein the first left interconnection line has a seventh end facing the first right interconnection line,
wherein the second left interconnection line has an eighth end facing the second right interconnection line,
wherein the third left interconnection line has a ninth end facing the third right interconnection line, and
wherein the seventh and ninth ends protrude beyond the eighth end in the first direction.

7. The semiconductor device of claim 5, wherein a shortest distance between the second right interconnection line and the second left interconnection line in the first direction is defined as a second distance, which is larger than the first distance.

8. The semiconductor device of claim 7, wherein the third left interconnection line has a ninth end facing the third right interconnection line, and
wherein a shortest distance between the third and ninth ends in the first direction is defined as a third distance, which is smaller than the second distance.

9. The semiconductor device of claim 1, wherein each of the first to third ends has a semi-oval profile, when viewed in a plan view.

10. A semiconductor device, comprising:
a first logic cell on a substrate, the first logic cell comprising a PMOSFET region and an NMOSFET region; and
a first metal layer on the first logic cell,
wherein the first metal layer comprises first lower interconnection lines and second lower interconnection lines, which extend in a first direction parallel to each other and are spaced apart from each other,
wherein the first lower interconnection lines comprise a first interconnection line and a second interconnection line, which are adjacent to each other among the first lower interconnection lines,
wherein the second lower interconnection lines comprise a third interconnection line between the first interconnection line and the second interconnection line,
wherein the first interconnection line comprises a first left end and a first right end, which are opposite to each other in the first direction,
wherein the second interconnection line comprises a second left end and a second right end, which are opposite to each other in the first direction,
wherein the third interconnection line comprises a third left end and a third right end, which are opposite to each other in the first direction,
wherein the first and second left ends protrude beyond the third left end in the first direction, and
wherein the first and second right ends protrude beyond the third right end in the first direction.

11. The semiconductor device of claim 10, wherein the first right end protrudes beyond the third right end by a first distance, and
wherein the first distance is in a range from 2 nm to 10 nm.

12. The semiconductor device of claim 10, wherein respective lengths of the second lower interconnection lines are smaller than respective lengths of the first lower interconnection lines in the first direction.

13. The semiconductor device of claim 10, further comprising:
a second logic cell adjacent to the first logic cell in the first direction; and
a second metal layer on the second logic cell,
wherein the second metal layer comprises a fourth interconnection line, and
wherein a shortest distance between the fourth interconnection line and the first interconnection line in the first direction is in a range from 12 nm to 18 nm.

14. The semiconductor device of claim 13, wherein the second metal layer further comprises a fifth interconnection line, and
wherein a shortest distance between the third interconnection line and the fifth interconnection line in the first direction is larger than the shortest distance between the fourth interconnection line and the first interconnection line.

15. The semiconductor device of claim 10, wherein each of the first to third left ends and the first to third right ends has a semi-oval profile, when viewed in a plan view.
